(19) Europäisches Patentamt
European Patent Office
Office européen des brevets

(11) EP 0 804 868 B1

(12) EUROPEAN PATENT SPECIFICATION

(45) Date of publication and mention
of the grant of the patent:
**28.03.2001  Bulletin 2001/13**

(51) Int Cl.[7]: **H05K 9/00**

(86) International application number:
**PCT/US96/00620**

(21) Application number: **96903530.2**

(22) Date of filing: **19.01.1996**

(87) International publication number:
**WO 96/22672 (25.07.1996 Gazette 1996/34)**

(54) **FORM-IN-PLACE EMI GASKETS**

IN SITU HERGESTELLTE EMI-DICHTUNG

JOINTS EMI MOULES SUR PLACE

(84) Designated Contracting States:
**DE DK ES GB SE**

(30) Priority: **20.01.1995  US 375853**
**24.01.1995  US 377412**

(43) Date of publication of application:
**05.11.1997   Bulletin 1997/45**

(60) Divisional application:
**00113095.4 / 1 041 869**

(73) Proprietor: **PARKER HANNIFIN CORPORATION**
**Cleveland Ohio 44112 (US)**

(72) Inventors:
• **BUNYAN, Michael, H.**
**Chelmsford, MA 01824 (US)**
• **KALINOSKI, John, P.**
**Chelmsford, MA 01824 (US)**
• **LUCIA, Russell, T.**
**Stoneham, MA 02180 (US)**

• **VILANDRE, Paul, R.**
**Salem, NH 03079 (US)**
• **WATCHKO, George, R.**
**Stoneham, MA 02180 (US)**
• **SHVARTSMAN, Rudolf, I.**
**Ballston Lake, NY 12019 (US)**
• **SORON, John, E.**
**Niskayuna, NY 12309-2507 (US)**

(74) Representative:
**von Fischern, Bernhard, Dipl.-Ing. et al**
**Hoffmann - Eitle,**
**Patent- und Rechtsanwälte,**
**Arabellastrasse 4**
**81925 München (DE)**

(56) References cited:
**EP-A- 0 194 230        EP-A- 0 200 296**
**EP-A- 0 588 321        DE-A- 4 219 915**
**DE-A- 4 237 217        US-A- 4 931 479**
**US-A- 5 049 332**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

**Description**

Field of the Invention

The present invention relates to an apparatus for extruding electrically-conductive polymeric material, and to a process for forming an EMI shielding gasket.

Background of the Invention

EMI shielding gaskets (EMI gaskets) are used on several types of electronic equipment to provide protection against interference from electromagnetic energy, including radio frequency interference (RFI) and more broadly all bands of interference commonly called electromagnetic interference (EMI). A shielding gasket includes an electrically conductive element, be it a wire mesh, conductive filler or conductive plating, coating or fabric which prevents external EMI from interfering with an electronic device and/or protects other adjacent electronic devices from EMI emitted by an electronic device.

Typically, EMI gaskets are prepared in one of three configurations: linear, die cut or molded. By linear, it is meant as an extrusion, molding, etc. of a defined, straight length. By die cut, it is meant that a gasket configuration is formed from an electrically conductive elastomer sheet material which is cut by a die to the desired shape, such as round, square, etc. By molded, it is meant that the gasket configuration is formed by placing uncured elastomer which may contain conductive filler or a conductive mesh, into a specifically designed mold which then is subjected to compression (pressure) and then cured to cause the elastomer to assume the desired gasket configuration.

All three methods have disadvantages especially when used to form complex multidirectional or multiaxial gaskets, such as may occur in devices with a number of compartments that each need to be shielded, from each other as well as the external environment. Moreover, the problems are even more critical on smaller devices, such as cellular phones, notebook computers and other hand held devices, where the diameter of the gasket becomes very small and the ability to manufacture and attach such gaskets securely becomes very difficult and labor intensive.

Using linear gasketing material to form complex multiaxis/multidirectional gaskets (e.g. either x and y or in the x, y and z planes), is difficult, time consuming and costly. Each gasket portion must be hand cut and bonded to the adjacent portions of other linear gaskets and then bonded or secured in position upon the substrate.

Die cutting of conductive sheet stock will work in many instances especially in two plane (e.g. flat; x,y) applications, provided that each portion of the gasket is wide enough and/or thick enough to be self supportive. Die cutting parts however results in significant waste of the sheet stock because the material is typically a cross-linked resin such as silicone or polyurethane. This is not acceptable as it drives up the cost of such parts unacceptably. Further as die cutting is a rough process, the sheet stock needs to be fairly stiff and self supportive which is opposite that desired by the gasket user (i.e. soft and flexible).

Molding is slow and again generates scrap in the form of flash which must be removed. Furthermore, each gasket design must use a specifically designed mold, making the process expensive for all but large volume stock items.

Document EP-A2-0 200 296 discloses a method of bonding a pair of substrates with a curable composition consisting of two parts A and B, said parts adapted to initiate cure of the composition upon mixing thereof, which method comprises extruding onto one substrate a sufficient quantity of the A and the B compositions in a single pass to cover the entire bond width when squeezed out by application of the second substrate and applying the second substrate, wherein the improvement comprises that the components A and B are each extruded as a plurality of beads in alternating adjacent A B A B fashion. This document additionally discloses an apparatus for applying to a substrate surface a curable composition consisting of two parts A and B adapted to initiate cure of the composition upon mixing, which apparatus comprises a dispensing head having a first and second extruding nozzle, each nozzle including a plurality of orifices, means for feeding parts A and B separately from respective reservoirs to the dispensing head and then to the nozzles of the first and second set respectively, the disposition of the nozzles in the dispensing head being such as to produce, on simultaneous extrusion of parts A and B through the respective first and second nozzle orifices onto a substrate surface in an extended pass, a web of composition consisting of discrete beads alternating in A B A B fashion.

Summary of the Invention

It an object of the present invention to provide a method of making a form-in-place EMI gasket, a system for forming complex multiaxis/multidirectional EMI gaskets in place with a minimum of generated scrap, and a form-in-place EMI gasket.

It is another object of the invention to provide means and methods for accurately and rapidly depositing a bead of material on a substrate, which method can eliminate or control drool formation.

Still another object of this invention is to provide apparatus for enabling extrusion of an EMI gasket material to form a gasket, which apparatus comprises gas pressure control means for controlling the rate of extrusion through an extrusion head or orifice to the atmosphere.

The present invention relates to an EMI shielding material that can be used to form a form-in-place EMI gasket, and a system for forming such a gasket using a table and/or dispenser capable of moving in multiaxial directions relative to each other and a substrate to be gasketed. The invention also relates to a process of providing a conductive elastomer, forming it in place along a desired gasket configuration so as to create a form-in-place EMI gasket.

The invention provides a process for forming an EMI shielding gasket according to independant claim 1. The gasket can be a heat-cured gasket. The process comprises the steps of placing a fluent electrically conductive polymeric material in an extruder chamber, applying positive and negative air pressure to the chamber to control the extrusion of the material from the chamber of a bead of the material, the material forming an individual EMI gasket having desires cross-sectional areas, the bead is then cured, for example by heating, to form the final EMI gasket.

The invention additionally provides apparatus for extruding electrically conductive polymeric material according to independent claim 25. The apparatus includes a chamber having a first and second end for holding fluent polymeric material, an extrusion head attached to the first end for extruding the fluent polymeric material through an extrusion orifice. The apparatus includes a source of positive gas pressure and a source of negative gas pressure connected to a control module. The control module has an outlet for selectively applying the positive and negative pressure to the chamber. A conduit which connects the outlet of the control module with the second end of the extruder chamber provides a selected amount of pressure to the second end of the extrusion head. The air pressure supplied to the extruder can be varied and is adjusted depending on the speed of the extrusion head, the amount of EMI shielding material in the extruder chamber the flow rate characteristics of the material, and the viscosity of the EMI shielding material. The bead formation can be precisely controlled by varying the air pressure very rapidly. To terminate the bead formation, the pressure on the fluent polymeric material is rapidly reduced by connecting the conduit to negative gauge pressure. Once the bead has been formed on the substrate, the electrically conductive material is subjected to a curing process to cure the EMI shielding material.

According to another embodiment the EMI shielding material is defined in part by a polymeric thermal addition cure system including an electrically-conductive filler. According to this and other embodiments, the polymeric system can include an elastomer base. The material desirably has bulk resistivity of less that about 0.050 ohm cm, and is readily extrudable. Upon exposure to a temperature of at least $85°C$ for a period of time of at least 30 minutes the material becomes essentially thermoset. The polymeric thermal addition cure systen is defined, according to one aspect, by a first species having a first functional group, a second species having a second functional group that is reactive with the first functional group in the presence of a catalyst and heat, and a catalyst having catalytic action that in the presence of heat catalyzes a reaction between the first and second functional groups.

The electrically-conductive filler preferably inhibits the catalyst to adversely affect the catalytic activity of the catalyst, yet the catalyst is present in an amount sufficient to retain desired catalytic activity. Methods and arrangements for retaining the catalyst in an amount sufficient to retain catalytic activity are provided, and according to one the shielding material is packaged as a kit. The kit includes a first container containing a first pre-mixed component including the first species, the electrically-conductive filler, and the catalyst, a second container containing a second pre-mixed component including the first species, the second species, and the electrically-conductive filler. The kit includes as well a third container containing the catalyst. By this arrangement, the third container is used to replenish catalyst that is inhibited by the electrically-conductive filler. By "inhibited" is meant chemically or physically affected in a way that catalytic activity is reduced.

According to one embodiment of the invention an EMI shielding material includes a siloxane polymer including vinyl functional groups, a siloxane cross-linker including reactive hydrides, a silver-containing electrically-conductive filler, and a platinum catalyst. The silver-containing electrically-conductive filler inhibits the platinum catalyst, thus methods and arrangements of the invention provide for replenishment of the catalyst to insure that sufficient catalytic action can be provided.

According to an embodiment of the process, the process includes the steps of extruding onto a substrate a free-form polymeric thermal addition cure system, which includes an electrically-conductive filler and which preferably has a viscosity of from about $10^3$ to about $10^5$ g cm$^{-1}$s$^{-1}$ (100,000 to about 10,000,000 centipoise), more preferably from about $10^4$ to about $4·10^4$ g cm$^{-1}$s$^{-1}$ (1,000,000 to about 4,000,000 centipoise). The system then is heated at a temperature and for a period of time sufficient to cure the system, thereby forming a gasket having bulk resistivity of less that about 0.050 ohm cm. The gasket can be formed without applying pressure, for example with a mold, to the extrudate. Prior to the extruding step, according to one aspect, the polymeric thermal addition cure system is prepared by forming a mixture of a first species having a first functional group, a second species having a second functional group that is reactive with the first functional group in the presence of a catalyst and heat, a catalyst that catalyzes a reaction between the first and second functional groups, and the electrically-conductive filler.

According to one aspect of the process, the polymeric addition cure system is prepared by mixing together a first pre-mixed component and a second pre-mixed component. The first pre-mixed component includes the first species, the electrically-conductive filler, and the catalyst. The second pre-mixed component includes the first species, the second species, and the electrically-conductive filler. Prior to mixing together the first and second components, additional catalyst can be added to the first pre-mixed component. This arrangement can be used when the catalyst has catalytic action that in the presence of heat catalyzes a reaction between the first and second functional groups, and the electrically-conductive filler inhibits the catalyst to adversely affect the catalytic activity of the catalyst.

The invention also provides an EMI shielded substrate. The shielded substrate includes a first electrically conductive substrate, a second electrically conductive substrate adjacent to the first substrate, and a formed-in-place electrically conductive gasket formed on and bonded to a predetermined portion of the first substrate so as to provide an electrical connection and EMI shielding between the first and second substrates. According to one aspect the first substrate is an enclosure and the second substrate is a cover for the enclosure. The first and second substrates can be formed of an electrically conductive material such as metal, metal plated plastic, metal/plastic laminate and composite, coated plastisol, or any combination of these. The gasket can be formed of an elastomer resin and rendered electrically conductive by the incorporation of one or more conductive fillers into the resin. The gasket can include more than one layer, with at least an outer layer being electrically conductive.

According to one embodiment the EMI shielded substrate includes a substrate having an electrically conductive surface, a cover for the substrate, the cover having an electrically conductive surface which corresponds to and is in register with the conductive surface of the substrate, and a formed in place electrically conductive gasket formed on and bonded to a predetermined portion of the conductive surface of the substrate or cover so as to provide an electrical connection and EMI shielding between the substrate and cover upon the mating of the cover to the substrate.

According to another embodiment of the invention a form-in-place EMI gasket is provided that includes a composition formed of a silicone resin, one or more conductive fillers, and a curing agent for the resin. The composition, when mixed and applied to a substrate, will create a form stable, form-in-place gasket capable of providing EMI shielding of from about 10 dB to about 120 dB over a frequency range from 10 MHZ to 12 GHz.

According to another embodiment the invention provides an EMI gasket that is made of a composition formed of a first component which is a primary polymer having end groups that are capable of chemically reacting with each other in the presence of moisture to form a derivative polymer having a longer average chain length than said primary polymer, a second component which is a non-crosslinked elastomer that is not substantially chemically reactive with itself or with said first component, and a third component which is one or more electrically conductive fillers. When the first, second, and third components are intimately mixed, the composition, when maintained in the absence of moisture and other active hydrogen donor materials, is readily extrudable and otherwise conventionally moldable thermoplastic composition. Upon exposure to moisture, however, the composition becomes essentially thermoset.

According to another embodiment, the invention provides a system for forming EMI shielded enclosures. The system includes a support platform, a compound applicator nozzle located above and in register with the platform, a supply of electrically conductive compound connected to the applicator nozzle, and a drive mechanism for moving the nozzle or platform relative to each other in one or more directions of travel. A curing chamber for curing the compound, after application, can be provided.

According to yet another embodiment, the invention provides a process for forming a form-in-place conductive EMI shielding gasket or a substrate that includes the steps of providing a substrate to be gasketed, providing a supply of conductive gasket material, applying the material to the substrate's surface in a predetermined pattern, and curing the material in place upon the substrate.

According to one aspect of all the embodiments herein, a primerless form-in-place gasket is provided.

Additional preferred embodiments of the invention are recited in the dependant claims.

The invention has broad applicability in form-in-place gasket applications including, but not limited to, application to the mating surfaces of cover pieces for electronic devices such as cellular phones, notebook computers and other devices requiring shielding. Additionally, a gasket can be formed on a removable cover which is fit to an access port of an electronic device.

These and other objects of the invention will become clear from the following description and claims.

Brief Description of the Drawings

Fig. 1 illustrates in planar view a preferred configuration of a form-in-place conductive EMI gasket, having a complex physical structure comprising a series of elongated sections in the x-y axis, on a desired substrate;
Fig. 2 shows in cross section a preferred embodiment of the gasket of Fig. 1;
Fig. 3 shows in planar view a preferred system for forming-in-place an EMI gasket, according to the present invention;

Fig. 4 shows another embodiment of a system of the present invention in cross section;

Fig. 5 shows a cross section of another preferred embodiment of the present invention;

Fig. 6 is a schematic illustration of an extruder apparatus;

Fig. 7 is a representation of a process of forming a bead on each of a plurality of substrates;

Fig. 8 is a representation of the process illustrated in Fig. 7 further including heat curing the beads in place on the substrates; and

Fig. 9 is a representation of a non-electrically-conductive bead formed by a prior art device showing excess material or drool in the bead.

Detailed Description of the Invention

The present invention relates to a form-in-place EMI gasket. Such gaskets are useful when positioned between two adjacent substrates such as a boxed cover, so as to form an electrical bridge or continuity between the two substrates and thereby prevent or reduce the potential for EMI.

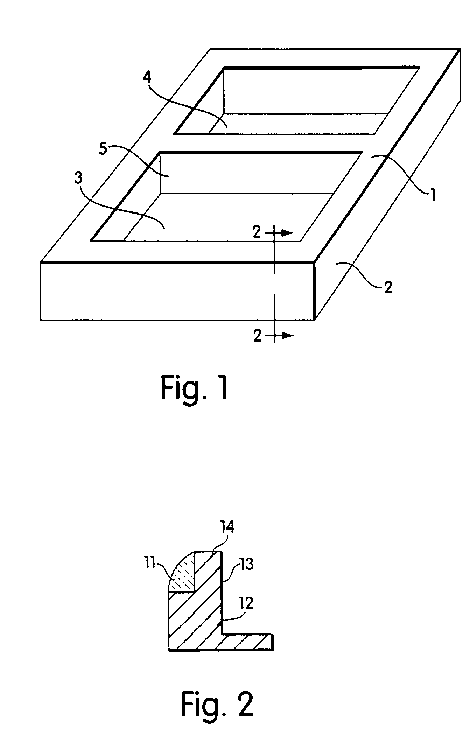

Fig. 1 shows a preferred embodiment of the present invention. The form-in-place conductive gasket 1 is mounted on a preselected section or sections of a substrate 2 which is to be shielded. In Fig. 1, the substrate 2 is a modular enclosure formed of two compartments 3, 4 separated by a wall 5. Such an enclosure can be a cellular phone carcass, a switching box, hard disk drive case, etc. As can be seen, the gasket 1 is formed in place along the edges of the enclosure which will mate with a cover (not shown).

Fig. 2 shows the conductive form in place gasket 11 in cross section as mounted to the enclosure 12. In this embodiment, the area of the enclosure to be gasketed 13 has a shoulder 14 against which the gasket is formed. Other embodiments may not have the shoulder 14, being flat instead, or may use other locating devices such as undercuts, dovetails, channels, etc. into which or against which the gasket may be formed.

The polymeric material that is the precursor is extruded onto a substrate, cured, and exhibits advantageous EMI shielding properties such as bulk resistivity of less than about 0.050 ohm cm. The gasket can be applied to any substrate, in any configuration, easily and in a cost effective manner with a minimal investment for tooling. Moreover, with the use of preprogrammable application equipment, one can store an infinite number of gasket configurations which can be called up and used quickly and repeatedly without the necessity to manufacture a specific die or a mold.

Additionally, it allows for the exact placement of very small diameter gaskets (e.g. 0.762 mm (.030 inch) diameter or less) which is difficult to achieve with all but molding.

The word "elastomeric" should be given its usual meaning given the purpose for which the invention is intended. The elastomer bases used in the invention can be thermosetting resins; e.g. resins which to cross-link and subsequently cure either at a critical temperature or in the presence of a curing agent/catalyst such as peroxide, photoinitiator, moisture, etc. Any flexible thermosetting elastomer base is suitable for use in the invention, such as EPDM copolymers, silicone rubbers, fluorosilicone rubbers, urethane rubbers, nitrile, rubbers, butyl rubbers, and mixtures thereof.

Elastomeric thermoplastics may also be used. Thermoplastic rubbers, such as various block copolymers (KRATON™ rubber, NORPRENE™ resin or SANTOPRENE™ resin) are particularly useful. Omission of other elastomers is not meant to specifically exclude their use in the invention. Certain physical or electrical requirements of the application for which the gaskets are intended may dictate that particular elastomeric compositions be used.

The selected material is preferably a fluent, hardenable polymeric material. By this definition is meant a polymeric material that has viscosity characteristics as described above, that can be readily extruded from an extrusion nozzle. The fluent polymeric material preferably has the following representative flow rate characteristics as described below, when the material is extruded through a 0.838 mm (0.033 in.) orifice 0.1024 mm (18 gauge) needle), at 1.379 bar (20 psi) the range of flow rates are (depending on changes in viscosity) 0.03-014 gm/min; at 2.758 bar (40 psi) the range of flow rates are 0.05-0.25 gm/min; at 4.137 bar (60 psi), the range of flow rates are 0.10-046 gm/min. When the material is extruded through a 1.372 mm (0.054 in) orifice 1.45 mm (15 gauge) needle at 1.379 bar (20 psi) the range of flow viscosity rates were 0.06-0.49 gm/min while at 2.758 bar (40 psi) the range is 0.19-1.25 gm/mim and at 4.137 bar (60 psi) the range is 0.36-2.62 gm/min. The fluent, polymeric material should be sufficiently viscous and/or form stable so that it does not slump, sag or run between the time of application and the time of curing. It may be in the form of a paste, a caulk, a gel or viscous fluid. Alternatively, when the material has a fast curing cycle or creates an initially stable material such as a gel or a skinned or foam structure upon application, the material as applied can be a relatively thin or non-viscous fluid.

In addition, the selected resin should form a soft, resilient, compression set resistant gasket even with the addition of relatively high loadings of conductive fillers, if used.

Preferred elastomers that meet the requirements above include silicone rubbers, whether foamed or unfoamed; silicone gels, whether foamed or unfoamed, typically such gels are relative soft silicone rubber which may have been extended with oils or plasticizers or which are only lightly cross-linked; polyurethanes, especially the prepolymer type of urethane in which the prepolymer is capped or terminated with an isocyanate group which when exposed to an activating agent (typically a hydroxy containing group), such as water, amines or alcohols cause the prepolymer to a cross-link; elastomeric thermoplastic rubbers such as DYNAFOAM™ and NORPRENE™ from Norton Co.; SANTOPRENE™ resin from Monsanto, and KRATON™ rubber from Shell Oil. These thermoplastics generally comprise at least a block copolymer, such as SBS or SIS rubber with or without other polymers (polyethylene, polystyrene, etc.) and/or oils or plasticizers. Additionally, various blends of the elastomers can be used as well.

Such polymers are generally known and widely available, see e.g. U.S. Patents 4,931,479, 4,643,924 and EP Patent Application 0326704A.

An EMI gasket can be formed of a composition as taught by EP Patent Application 0326704A by using a two-component polymer system, one which is thermoplastic in nature, the other being thermoset when exposed to moisture or active hydroxyl groups. According to one embodiment the gasket includes the following three components. The first component is a primary polymer having end groups that are capable of chemically reacting with each other in the presence of moisture to form a derivative polymer having a longer average chain length than said primary polymer, such as an isocyanide capped polyester prepolymer. The second component is a non-crosslinked elastomer that is not substantially chemically reactive with itself or with said first component in the presence of moisture, such as a block copolymer e.g. styrene-butadiene-styrene block copolymers. The third component is one or more electrically conductive fillers. The first, the second, and the third components are intimately mixed, and the composition, when maintained in the absence of moisture and other active hydrogen donor materials, form a readily extrudable and otherwise conventionally moldable or coatable thermoplastic composition but, upon exposure to moisture, becomes essentially thermoset. One preferred embodiment of the invention utilizes thermal addition cure systems.

Silicone-based polymeric materials suitable for use include those available from Dow Coming Corporation as SYLGARD™ 527 (Parts A and B), DOW CORNING 3146, those available from GE Silicone as one-part RTV silicone material including primerless adhesive RTV 6802, 6803, 6808, 6809, general purpose adhesive RTV 6702, 6703. 6708, fast-curing primerless adhesive RTV 5812, 5813, 5818 and two-part RTV materials, also Shin-Etsu (Torrance, CA) selfpriming (primerless) KE 1800 T, KE 109 RTV silicones (2-component) or KE 1820, KE 1830. A suitable material can be mixed with one or more conductive fillers to form an EMI material.

The gasket may be rendered electrically conductive either through the use of a conductive filler incorporated into the elastomer base and/or the use of an electrically conductive outer layer formed over a core which may be conductive or nonconductive.

The fillers that are used to impregnate elastomers to make them electrically conductive are well-known in the art. Examples of these fillers include but are not limited to electrically conductive noble metal-based fillers such as pure silver; noble metal-plated noble metals such as silver plated gold; noble metal-plated non-noble metals such as silver plated copper, nickel or aluminum, for example, silver plated aluminum core particles or platinum plated copper particles; noble-metal plated glass, plastic or ceramics such as silver plated glass microspheres, noble-metal plated alumina or noble-metal plated plastic microspheres; noble-metal plated mica; and other such noble-metal conductive fillers. Non-noble metal-based materials are also suitable, including non-noble metal-plated non-noble metals such as copper-coated iron particles or nickel plated copper; non-noble metals, e.g. copper, aluminum, nickel, cobalt; non-nobel-metal-plated-non metals, e.g., nickel-plated graphite and non-metal materials such as carbon black and graphite combinations of the fillers to meet the desired conductivity, hardness and other parameters desired for a particular application.

The shape and size of the electrically conductive fillers is not critical to the present invention. The fillers may be of any shape that is generally used in the manufacture of conductive materials, including spherical, flake, platelet, irregular or fibrous (such as chopped fibers). In making gaskets in accordance with the invention it is preferred that the particle shape be spherical, substantially spherical or irregular. Flake or platelet shaped fillers are preferred when used in forming an outer conductive coating for the foam-in-place gasket.

The particle size of the electrically conductive fillers can be within the range normally used for fillers in conductive materials. Generally the particle size of the one or more fillers is from about 0.250 µm to about 250 µm, preferably from about 0.250 µm to about 75 µm, and most preferably from about 0.250 µm to about 60 µm.

The fluent, hardenable polymeric material of the invention has a viscosity of from about $10^3$ to about $10^5$ g cm$^{-1}$s$^{-1}$ (100,000 to about 10,000,000 centipoise). Viscosity is measured at 25°C using a Brookfield Viscometer (RV series) Heliopath Stand, "F" T-Spindle (1-2.5 RPM), Brookfield Engineering Labs, Inc., Stoughton, Mass. Viscosity can be adjusted by, for example, addition of a silicone fluid.

The amount, or loading, of the one or more electrically conductive fillers in the conductive elastomeric material used in the present invention can vary over a wide range, as long as the electrically conductive filler is present in an amount sufficient to provide EMI/RFI shielding properties. Generally loading of the filler particles in the conductive elastomeric material is from about 10 to about 80 volume percent, preferably from about 20 to about 66 volume percent.

When a conductive outer layer is used to provide the conductivity to the gasket, it may be in the form of a plating, a coating or a film. Plated layers, such as silver plating, are not preferred as the platings tend to be rigid and crack under compression. Films, such as a conductive filled polyethylene or polyimide, may be used.

Preferably, the outer conductive layer is some form of conductive coating. More preferably it is a conductively filled resilient coating. Such coatings can and preferably are based upon the same elastomer resin that is used to form the inner layer. Preferred coatings include silicone, polyurethane, acrylic and epoxy resins filled with one or more of the conductive fillers in the same size range and amounts as described above.

Other fillers and ingredients may also be added to the elastomer base if desired. Such fillers include microwave absorbing materials, thermally conductive fillers, inert or reinforcement fillers such as silicas and pigmentation fillers, also glass or polymeric microspheres. Additionally, curing agents, cross linking agents, flame retardants, diluents, solvents or dispersion aids, etc., may be added as is well known in the art to form the desired conductive elastomeric material. The elastomers may in addition comprise other compounds, such as plasticizers, extender oils, softeners, tackifiers catalysts, blowing agents or other agents that impart desired properties to the cured gasket.

Typically, the gasket should have a Shore A hardness (as measured by ASTM standards) of less than 90, preferably between 5 and 80, more preferably 5 and 50 and more preferably between 5 and 40. The properties of the gasket will vary depending upon the resin chosen, whether it is foamed or not, the amount of filler contained therein and the other constituents (oils, plasticizers, reinforcing fillers etc.) that may be added.

A typical form-in-place gasket should have a low closure force, e.g. a force of less than about 892.9 g cm (5 pounds/linear inch), preferably less than 535.7g cm (3 pounds), and more preferably less than 178.6 g cm (1 pound) to deflect the gasket sufficiently to ensure proper electrical continuity between the two adjacent substrates.

The gasket should be capable of being dispersed by automated equipment (if so desired) in diameters ranging from about 0.254 to 6.35 mm (.010 to 0.25 inch) wide and aspect ratios as from about .25 to 1 to about 3 to 1.

EMI Shielding effectiveness should be at least 10 dB, preferably at least 20 dB over a range of frequencies from about 10 MHZ to 12 GHz. More preferably, it should provide an EMI shielding effectiveness of from about 10 dB to 120 dB, preferably from about 20 dB to 80 dB, over a frequency range of from about 10 MHZ to 12 GHz, preferably from about 200 MHZ to 10 GHz. Shielding effectiveness will of course vary with the amount of conductive material present, the deflection imposed upon the gasket and the test method used. All shielding effectiveness values above assume a typical loading of conductive materials as referenced above, with at least 10% deflection, preferably 10 to 50% deflection and standard MIL-G-83528 test procedures.

The process of applying such form-in-place conductive elastomers preferably includes the use of automated equipment such as robotic applicators, such as x-y, x-y-z and other such multiaxis or rotational type of applicators; hand applicators such as caulking guns; transfer applicators and other such processes.

Preferably, the process relates to the formation of an elastomer which is capable of being formed in place, applying the elastomer to a substrate along a predetermined pathway and curing the elastomer in place. This means that a free-form polymeric material, for example a free-form polymeric thermal addition cure system, is extruded onto a substrate and cured. "Free-form" means that the extrudate assumes a desired shape and is cured without the use of a mold. The extrudate can be cured without a mold as well, preferably at atmospheric pressure.

According to a preferred embodiment, excellent adhesion of the materials and gaskets of the invention to substrates onto which they are applied and cured is realized without the use of primer. If desired or required, however, due to the elastomer resin selected and/or its adhesion to a certain substrate, a bonding agent or primer may be used. For example, some silicone compositions are known to have poor adhesion properties, especially to metal substrates a primer, such as a functionalized silane, silicate ester, a cyanurate or a silicone based adhesive may be used to cause the silicone composition to adhere to the metal substrate. In the preferred embodiments, even when primerless materials are used the force of cohesion within the gaskets formed is less than the large force of adhesion to the underlying substrate. Thus good bonding to substrates is obtained.

One preferred process is to use a stationary support or table to which the substrate to be gasketed is fixed in place, a movable applicator, such as a programmable x-y or x-y-z nozzle, which is connected to a supply of form in place elastomer, is positioned adjacent and preferably above the substrate and then caused to travel along a predetermined path, applying the elastomer to the portion of the substrate over which it travels in a desired amount. The elastomer then is cured.

Alternatively, the nozzle may be stationary and the table may be caused to move in two (x-y), three (x-y-z) or more planes of movement.

In a further embodiment, both the nozzle and the table may move in one or more planes relative to each other. One example is where the nozzle moves in two planes (x-y) and is rotational as well and the table is capable of vertical (z) movement. Other variations and embodiments can be used as well.

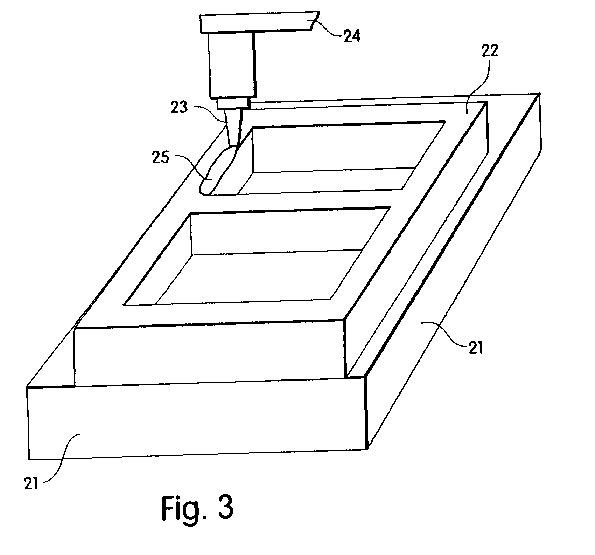

A typical system for performing the process is shown in Fig. 3 wherein a support platform or table 21 has a substrate to be gasketed 22 mounted upon it. An applicator, such as the lining dispenser 23 is located over the platform 21. The dispenser is connected to a supply (not shown) of form in place elastomer via a conduit 24.

The dispenser 23 is capable of moving in at least two planes of motion relative to the platform, such as in the x and y axes. Preferably, it is capable of moving in three planes of motion (x, y, z) and may also be rotational so as to accommodate changes in the height or the angle of the substrate 22 over which it passes and applies the elastomer to form a gasket 25 at a desired position.

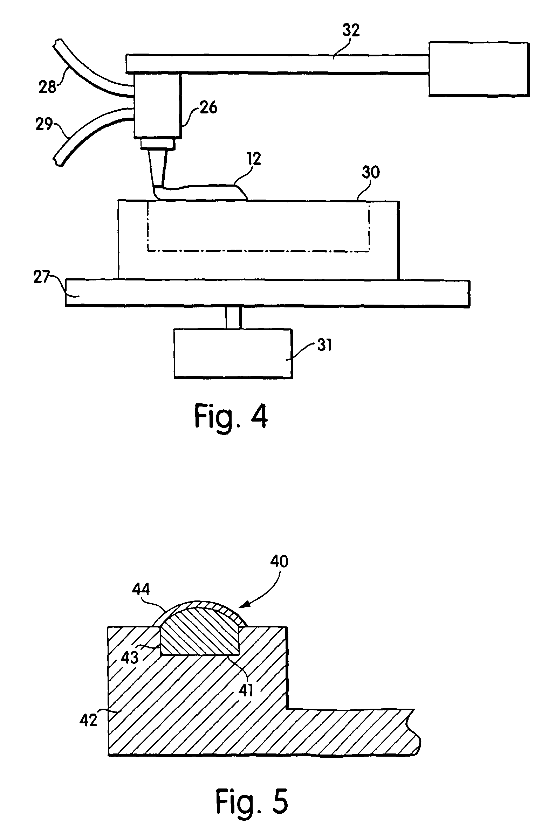

Fig. 4 shows another typical system in which the dispenser 26 and the table 27 move relative to each other. Also in this instance, the nozzle has two supply lines 28, 29 which allows for the use of two component systems such as urethanes or the introduction of a gaseous component (air, $CO_2$, nitrogen) into the elastomer just before application so as to form a foamed structure. The table 27 to which the substrate 30 is mounted is moved in one or more directions (x, y and/or z) by a drive mechanism as represented by box 31. The nozzle is moved via a similar drive mechanism 32.

One method of forming the form in place gasket is to mix a silicone rubber, preferably in the form of a low Shore A siloxane polymer with electrically-conductive filler in an amount sufficient to provide EMI shielding. The mixture is then mixed with additional silicone rubber and/or a curing agent or catalyst and then added to a syringe applicator mounted on an x-y applicator arm. The material is then dispersed along a peripheral edge of a substrate, such as a cellular phone housing where it cures in place.

Another method is to form a nonconductive elastomer gasket layer, such as by the process described above and then forming a conductive outer layer over the nonconductive core via spraying, coating, painting or dipping a conductive outer layer onto the core. Fig. 5 shows such an embodiment. The gasket 40 is contained in a channel 41 formed in a substrate 42. The inner layer 43 is covered at least partially with a conductive outer layer 44. The inner layer 43 is preferably nonconductive. However, if desired, it could be conductive, containing e.g. carbon black as a filler.

Alternatively, the nonconductive core can be coated with an adhesive layer which then is flocked with conductive fibers, as taught by U.S. Patent 5,115,104.

The gasket may be cured by any of the mechanisms commonly used for the selected polymer so long as the cure does not adversely affect the slump properties of the gasket between application and cure, and/or the physical or electrical properties of the cured gasket.

Some elastomers such as prepolymer based polyurethanes are basically self-curing in that once the reaction between the isocyanate group and hydroxy group begins, it typically continues until one or both groups are expended.

Other elastomers, such as some silicone and thermoplastic rubbers use chemical curing agents such as peroxide, sulfur, zinc or amines and/or heat to cross-link and cure the resin.

Photocurable resins may also be used via the incorporation of a light sensitive curing agent or photoinitiator which upon exposure to a certain wave length of light (UV, etc.) causes the resin to cross-link and cure.

Some resins use heat to cure. In a particularly preferred embodiment of the invention, a polymeric thermal addition cure system in the form of a hardenable fluent polymeric extrudate is cured in an oven. In addition, in heat cure systems one may warm a substrate before, during or after application (especially if it is metal) of hardenable fluent polymeric material in order to hasten the cure and avoid problems of a cool substrate coating as a heat sink and drawing away heat from the resin. Alternatively, the resin can be heated in an extruder container or passage such as a nozzle just before application. The use of hot air or infrared heaters adjacent the substrate may be used.

Hot melt resins such as those based upon KRATON™ rubbers typically need to cool in order to set. Affirmative cooling of the substrate in this instance may be useful. Those hot melts which contain a cross-linking agent may actually need to be kept at an elevated temperature (albeit it below the melting point of the resin) in order to cross-link.

In accordance with a particularly preferred embodiment of the invention, a polymeric thermal addition cure system, and an electrically-conductive filler, form an EMI shielding material which can be extruded and then heat cured. Polymeric thermal addition systems are known, and many such systems suitable for use in the invention are cured through reaction between functional groups on adjacent molecules, which functional groups and molecules can be the same or different. For example, the invention finds utility with a single species that is a polymer that can be cross linked, chain extended, or both.

First and second species having first and second functional groups, respectively, can be reacted as well to cure and harden a fluent polymeric material. The first species is generally polymeric, and the second species a cross linker, although both the first and second species can be polymeric. The first and second species have adequate functionality such that a thermally-activated cross linking reaction results in hardening of the material to an extent that a gasket having mechanical properties desirable in an EMI shielding gasket results.

The first species is preferably a polymeric species of a size and structure that results in the material being fluent and extrudable, generally with a viscosity of from about 5,000 to about 10,000 g $cm^{-1}s^{-1}$ (poise) at 25°C. The polymeric species can be a linear, branched, or radial homopolymer; random copolymer, or block copolymer, including polymeric species described above, and can include terminal reactive functional groups, internal (non-terminal) reactive functional groups, or both. The first species can include phenylmethylvinyl and divinylmethyl materials. According to a particularly preferred embodiment, the first species is a linear vinyl-terminated siloxane polymer, such as vinyl-terminated polydimethyl siloxane, and the second species is as hybrid cross-linker such as a hydride terminated siloxane, or a methylhydrodimethylsiloxane copolymer with 20-60% methyl hydrogen, a catalyst, such as a platinum catalyst, typically is necessary to catalyze the addition cure reaction between the first and second species. Platinum catalysts are known to those of ordinary skill in the art, typically embodied as organoplatinum species.

Siloxane-based polymeric thermal addition cure systems are commercially available, for example from Dow Chemical, GE Silicone, or Shin-Etsu Company: Such systems are generally sold as a two-component system, the first component including a vinyl-containing siloxane and about 5-10 ppm platinum catalyst, and the second component containing a hydride functional siloxane and a vinyl-containing siloxane. The first and second components are mixed and heat cured, resulting in a form-stable material.

The polymeric thermal addition cure system becomes essentially thermoset upon exposure to a temperature of at least 85°C for a period of time of at least 30 min. Typically, temperatures of from about 85°C to about 180°C are employed, and heat is applied to the system for period of time ranging from about 30 minutes to about 160 min. Preferred systems are cured at about 150°C for about 30 minutes, at about 120°C for about 60 minutes, or at about 85°C for about 120 minutes. Those of skill in the art can adjust the time and temperature of curing to suit a particular system. For example, if a temperature as high as 250°C is used, the curing time may be as short as 1-5 minutes.

Preferred polymeric addition cure systems, such as siloxane-based systems, will adhere to a substrate upon which they are cured without the use of a primer. Substrates to which the system will adhere when cured thereon include plastics, metals, ceramics, silica, and the like.

In accordance with the invention, an electrically-conductive material is mixed with the first and second components of a two-component thermal addition cure system, and when the components are mixed and heat cured, a form-stable EMI shielding material results. When a silver-based electrically-conductive material (such as silver powder, silver-plated metal, ceramic or polymeric particles, or silver-impregnated particles) is used, however, the silver acts to adversely affect the catalytic activity of the catalyst, especially a platinum catalyst. Therefore, when the above-described first and second pre-mixed component are stored, over time the silver-based filler inhibits the platinum catalyst to adversely affect the catalytic activity of the catalyst. Thus, the replenishment of catalyst is controlled in accordance with the invention to counteract the conductive filler poisoning of the catalyst resulting from storage and use of the system.

According to a particularly preferred embodiment of the invention, a method involves providing several pre-mixed components and mixing together the components to form EMI shielding material that can be extruded to form a gasket. The components are formulated such that predetermined amounts of each are blended together prior to extrusion, where the predetermined amounts are conveniently deliverable and blendable. For example, the components can be prepared such that a ratio of the first to the second of approximately 1:1 can be blended prior to extrusion.

A three-component system is provided that includes one pre-mixed component that can include the first species, the electrically-conductive filler, and the catalyst, a second component can include the first species, the second species, and the electrically-conductive filler, a third component can be provided that includes the catalyst in a suitable carrier, such as a silicone fluid or silicone-compatible fluid, an organic solvent such a toluene, alcohol, or the like, or one of the first or second species, a cure accelerator, such as sold by Dow Coming as Q3-6559, as well as other cure accelerators having relatively high catalyst content, is suitable for use as the catalyst-replenishing third component. The method can involve mixing the first and second components together and then adding the third component prior to extrusion or mixing the first component with the third component, then adding the second component prior to extrusion. While not preferred, the second and third components can be mixed, followed by addition of the first component prior to extrusion.

According to another embodiment of the invention, a two-component system is provided that includes one pre-mixed component that can include the first species, the second species, the electrically-conductive filler, the catalyst, and an inhibitor. The inhibitor prevents reaction between the first and second species at room temperature, but at curing temperatures is volatilized, allowing reaction between the first and second species. A second component includes the catalyst in a suitable carrier. According to this embodiment, when a hydride-containing siloxane is used in the curing reaction, it is advantageously replenished if the system is stored for longer than one day. The amount of hydride needed to replenish the system is dependent upon the length of time of storage. According to this embodiment, the method involves mixing the first and second components together just prior to extrusion.

According to one embodiment, polymeric microspheres can be added to the polymeric addition cure system prior to curing. Such polymeric microspheres are known in the art and are formed of phenolic material, acrylonitrile-based material, or the like, depending upon the physical properties desired. Such microspheres can be made to be compressible, such that upon compression the viscosity of material containing the sphere drops. The spheres can also be made to contain a volatile species such as a hydrocarbon core contained within a polymeric shell, and upon exposure to heat, the hydrocarbon expands to expand the sphere. Acrylonitrile microspheres of 5-200 μm size, averaging 25 μm, are suitable for use in the invention.

An EMI shielding gasket is formed by extruding from an extrusion head a fluent polymeric material that is a blend of a three-component polymeric thermal cure system including electrically-conductive filler particles.

The three-component system is formulated as follows. A first pre-mixed component is a 12.25 parts/wt vinyl terminated siloxane polymer and platinum catalyst containing 48 parts/wt silver-plated copper particles (electrically-conductive particles), and 0.2 parts/wt 25 μm acrylonitrile microspheres. a second pre-mixed component is a mixture of a 12.5 parts/wt hydride-terminated siloxane polymer and vinyl-terminated siloxane polymer, 48 parts/wt silver-plated copper particles, 0.2 parts/wt 25 μm acrylonitrile microspheres, and 0.2 parts/wt fumed silica. The first and second components, absent the microspheres, the electrically-conductive particles, and the fumed silica, are available commercially from Dow Corning as SYLGARD™ 527A and 527B. In other examples, GE Silicone 6196 (Parts a and B), or Shin-Etsu KE 1800T and KE 109 RTV silicones, respectively, are used. Into the first and second components is mixed a third component that is 0.25 parts/wt of a cure accelerator containing a platinum catalyst, available from Dow Corning as Q3-6559, and 0.75 parts/wt of a silicone fluid, available from Dow Coming as low-viscosity 200 fluid.

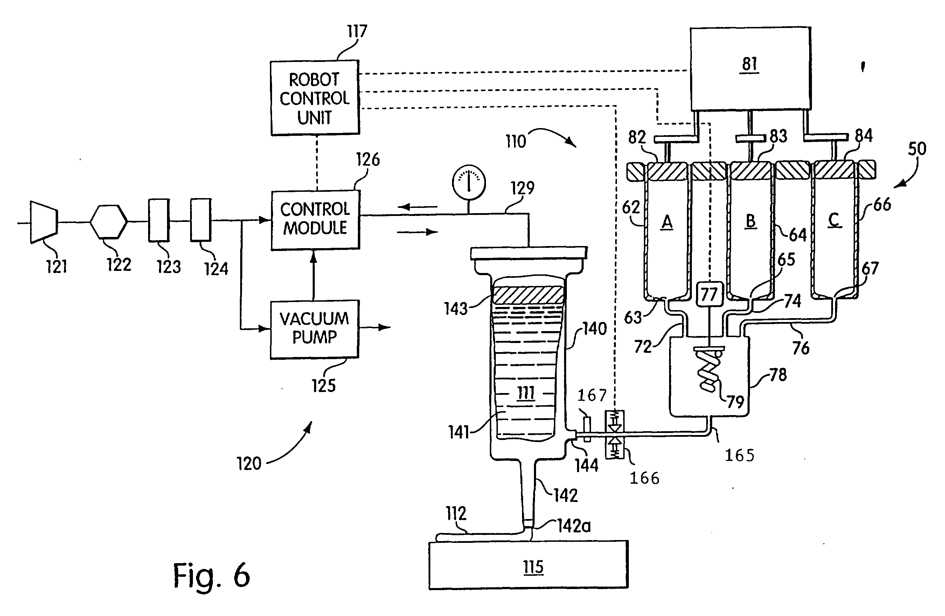

Predetermined quantities of the first, second, and third components are loaded into respective containers of a material supply and extrusion system illustrated in Fig. 6 and described more fully below. The percentages by volume of the first, second, and third components added to form the fluent, polymeric mixture are approximately 19, 19, and 1, respectively, according to one embodiment. The first and third components can be mixed prior to addition of the second component. The product can be heat cured in place, for example at a temperature 138°C for one-half hour.

Next is described apparatus for forming a bead of curable material on a substrate.. Any of the materials described above, in addition to other materials, can be extruded using the apparatus. The apparatus can be used to extrude material evenly, rapidly, and without overrun. In a preferred embodiment of the invention, the apparatus comprises an extruder having a chamber for holding a supply of electrically conductive material having a viscosity from $10^3$ through $10^5$ g cm$^{-1}$s$^{-1}$(100,000 through 10,000,000 centipoise). Preferably the material has a viscosity from $10^4$ to $4 \cdot 10^4$ g cm$^{-1}$s$^{-1}$(1,000,000 to 4,000,000 centipoise). An extrusion head is mounted on the extruder and is connected with the chamber for extruding the bead of EMI shielding material on the substrate, the head is movable with respect to the substrate. A vacuum pump provides a negative gauge pressure and a compressor provides a positive gauge pressure. Each are connected to a control module which is adapted to control the amount of air pressure acting on the EMI shielding material. The air pressure supplied to the extruder can be varied and is adjusted depending on the speed of the extrusion head, the amount of EMI shielding material in the extruder chamber the flow rate characteristics of the material, and the viscosity of the EMI shielding material. The bead formation can be precisely controlled by varying the air pressure very rapidly. To terminate the bead formation, the pressure on the fluent polymeric material is rapidly reduced by connecting the conduit to negative gauge pressure. Once the bead has been formed on the substrate, the electrically conductive material is subjected to a curing process to cure the EMI shielding material.

Fig. 6 shows a schematic diagram of an apparatus indicated generally at 110, for forming a bead on a substrate which may be cured after forming. The apparatus has an extruder 140, a pressure supply system indicated generally at 120 and a material supply system indicated generally at 50.

The apparatus 110 provides a predetermined quantity of fluent polymeric material 111 supplied to the extruder 140 which has a chamber 141. The fluent polymeric material 111 is forced out of the extruder chamber 141 through an orifice 142a of an extrusion head 142 by air pressure, which is supplied by the pressure supply system 120, on the surface of the fluent polymeric material 111. The pressure supplied to the extruder chamber 141 is adjusted by a control module 126 and can be varied. As the fluent polymeric material is forced through the extrusion head 142, the head moves along a predetermined path to form a bead 112 of polymeric material. The bead 112 which is formed along the desired path is cured to form the final EMI shielding gasket. The bead formation is terminated as where a continuous encircling gasket is formed, by reducing the pressure in chamber 141, preferably very rapidly, to a negative gauge pressure, which can be as low as -0.912 bar (-0.9 atm), or lower.

The extruder 140 is mounted on a robotic applicator which is a commercially available programmable X, Y, Z coordinate machine. In the preferred embodiment, the head moves relative to the position of a substrate 115, which is fixed in place during the extrusion process a robotic control unit 117 controls the movement of the robot and the extrusion apparatus. A suitable robotic applicator is available from Robotics Inc. located in Ballston Spa, New York.

The material supply system 50 is designed to feed a predetermined amount of material into the extruder chamber 141. The material which is being extruded can be a hardenable, fluent polymeric material. By this definition is meant a polymeric material that has viscosity characteristics as described above, that can be readily extruded from an extrusion nozzle, and that is thermosetting, thermoplastic, or otherwise hardenable. The material can be a one-component elastomer or resin that is cured via heat, moisture, light, or chemical means. Any flexible setting resin is suitable for use in the invention, such a EPDM copolymers, silicone rubbers, fluorosilicone rubbers, urethane rubbers, nitrile rubbers, butyl rubbers, and mixtures thereof. Thermosetting or thermoplastic materials can be used. The selected material should be sufficiently viscous and/or form stable so that it does not slump, sag or run between the time of application and the time of curing. It may be in the form of a paste, a caulk, a gel or viscous fluid. Alternatively, when the material has a fast curing cycle or creates an initially stable material such as a gel or a skinned or foam structure upon application, the material as applied can be a relatively thin or non-viscous fluid.

The selected resin should form a soft, resilient, compression set resistant gasket even with the addition of relatively highloadings of conductive fillers, if used. Preferably the final gasket is elastomeric and can have a continuous encircling configuration. When the polymeric material is in its fluent state, it preferably can be compressible to about 95% of its uncompressed volume when positive gauge pressure in the operational range of the machine is applied.

When the polymeric material is compressible, part of the pressure applied to the extruder chamber during the extruding operation is absorbed by the material as it compresses. This results in a lag time and a sluggish response to the application of pressure in the extrusion process. The sluggish response further complicates the termination of the extrusion of the bead because of the energy which is stored in the compressed material. Of course, the process and apparatus of the invention can be practiced with an incompressible fluent polymeric material.

The fluent polymeric material preferably has the following representative flow rate characteristics as described below, when the material is extruded through an 0.838 mm (0.033 in.) orifice (0.1024 mm (18 gauge) needle), at 1.379 bar (20 psi) the range of flow rates are (depending on changes in viscosity) 0.03-014 gm/min; at 2.758 bar (40 psi) the range of flow rates are 0.05-0.25 gm/min; at 4.137 bar (60 psi), the range of flow rates are 0.10-046 gm/min. When the material is extruded through a 1.372 mm (0.054 in) orifice (1.45 mm (15 gauge) needle) at 1.379 bar (20 psi) the range of flow viscosity rates were 0.06-0.49 gm/min while at 2.758 bar (40 psi) the range is 0.19-1.25 gm/min and at 4.137 bar (60 psi) the range is 0.36-2.62 gm/min.

The viscosity of the fluent polymeric material is between about $10^3$ and about $10^5$ g cm$^{-1}$s$^{-1}$ (100,000 and about 10,000,000 centipoise). Preferably, the range is between $10^4$ and $4 \cdot 10^4$ (1,000,000 and 4,000,000). The viscosity is measured by a Brookfield Viscometer (RV Series), Heliopath stand with an "F" T-spindle 1-2.5 rpm. The viscometer is available from Brookfield Engineering Labs, Inc., Stoughton, MA.

The Polymeric Material Supply System

The material can be supplied in three constituent parts which are mixed prior to extrusion. As described above, the components could have a limited shelf life and provide the highest quality bead when mixed shortly before the extrusion process. The components can be mixed on-line, that is, supplied to the extrusion apparatus in component parts and subsequently mixed in the apparatus. Alternatively, the components can be mixed off-line and then supplied to the extrusion apparatus ready to be extruded. Alternatively, the invention can be practiced with a single component fluent material which is inserted into the extrusion chamber.

As shown in Fig. 6, constituent material A, B and C are inserted into elongated, tube, cylindrical chambers 62, 64 and 66 respectively. As an example of a three-constituent combination which would be combined to form the fluent polymeric material, A can contain a resin, B can contain a cross-linking agent, and C can contain one or more additives such as polymeric microspheres, silicone fluid, cure inhibitor, catalytic cure accelerator, fumed silica, colorant, or the like, carried in a suitable carrier including the resin or the cross-linking agent. Resins and cross-linking agents, such as siloxane-based resins and cross-linking agents, are known. A proportioning pneumatic cylinder 81 controls the motion of three rams 82, 83, 84 which sealingly slide within one end of each of the chambers 62, 64, 66, respectively. The proportioning cylinder 81 is controlled by the robotic control unit 117. Each ram is adapted to individually and independently slide within the cylinders to force a predetermined amount of component material out of the cylinder through orifices 63, 65, and 67 of cylinder 82, 83 and 84 respectively. Conduits 72, 74 and 76 connect each orifice 63, 65 and 67, respectively, to an elongated, cylindrical mixing chamber 78.

The constituent materials are then mixed in the mixing chamber 78 by a dynamic mixer 79 which in the preferred embodiment is an elongated helical screw. The dynamic mixer 79 is rotated by a motor 77 which is controlled by the robotic control unit 117. The mixing chamber 78 is connected to the extruder chamber 141 by a conduit 165. A valve 166 is disposed along conduit 165 to control the flow of material such that a predetermined amount of polymeric material is allowed to fill the chamber. The valve 166 is shown to be a pinch valve, of course one skilled in the art will recognize the wide variety of valves which are suitable for the purpose of controlling the flow of fluid through conduit 165 and for making sure a predetermined amount of fluent polymeric material flows into the chamber 141. A pressure transducer 167 located between the valve 166 and the cylindrical extruder chamber 141 operates to monitor the pressure in the cylinder.

In a second mode of operation of the extruding apparatus the material 111 is formed from only two combined components. The two components are placed in cylinders such as 62 and 64 and then are mixed in the mixer chamber 78 by the dynamic mixer 79. When two components are used to form the fluent polymeric material, one component could be a mixture of resin and cross-linker and the other component could be catalyst, or one component could be a resin and the other a mixture of the cross-linker and the catalyst, or other formulation.

A third mode of operation of the extruding apparatus is a single component system. In this mode of operation, the single component is placed into a single cylinder and fed through the conduit 165 directly. In some cases it may be advantageous to feed the single component material through the mixer chamber 78 and mixed by the dynamic mixer 79 to ensure a homogenous mixture is fed to the extruder chamber 141.

The Extruder

The cylindrical extruder chamber 141 is adapted to hold fluent polymeric material. An air conduit 129 is fluidly connected to the upper portion of the cylinder and provides air pressure to the chamber 141. A cap 143 is slidingly received in the chamber and separates the pressurized air from the fluent polymeric material, thus keeping the fluent polymeric material free from foreign particles which may be in the air. The chamber also has an inlet 144 through which the fluent material flows from the conduit 165. In the preferred embodiment of Fig. 6, the extruder chamber 141 has a volume of about 30 cc.

At the lower end of the extruder 140 is the extrusion head 142 which has an orifice 142a through which the material is extruded to form the bead. The extrusion head, also known as a needle, has an orifice diameter of about 0.635 to about 2.286 mm (.025 in. to about .090 in). Preferably, the diameter is about 0.838 (.033 in). The needle has a decreasing diameter along the axial length towards the orifice to enhance the material flow properties though the needle.

The Pressure Supply System

Again with reference to Fig. 6, the extrusion of the polymeric material 111 is controlled by the pressure supply system 120 which is adapted to provide both a positive and negative pressure to the extrusion chamber 141. An external source such as an air compressor 121, provides a source of positive pressure for the system. Any commercially available air compressor which supplie 1103.2 kPa (160 psi) of pressure is suitable for use. The air compressor is fluidly connected to a gas pressure regulator 123 which controls the pressure of the air supplied to the system. This pressure regulator 123 is used to provide broad control of the pressure supplied to the system, and generally does not change during the operation of the extrusion process. An air filter 122 is disposed between the air compressor and the pressure regulator to clean the air which is supplied to the system. A solenoid valve 124 is provided on the pressure line to isolate the pressure from the system at desired intervals during the bead extrusion process.

A vacuum pump 125 is provided in the system 120 to supply a negative pressure or vacuum to the extrusion chamber at predetermined intervals in the extrusion process, for example, when the bead formation is to be terminated as after formation of a continuous encircling bead which is to be cured to form as gasket. The vacuum pump is commercially available and provides a vacuum of about -0.912 (-0.9 atm). The vacuum pump is powered using the pressure from the air compressor in a manner well known to those skilled in the art.

A control module 126 receives both the positive pressure supplied by the air compressor 121 and the negative pressure supplied by the vacuum pump 125 and supplies a selected pressure to the extruder chamber 141 through a fluid line 29. A pressure gauge (not numbered) is disposed between the control module and the extruder chamber. The control module responds to a signal from the robot control panel and is a 24 volt DC binary pressure converter. The control module used in the preferred embodiment is an ABR Regulating valve which is available from Parker Hannifin, of Cleveland, OH. The pressure supplied to the extrusion chamber by the control module varies at 25 increments of positive pressure and 25 increments of negative pressure. The response time of the control module is 20 milliseconds which facilitates a quick response to a start or a stop command from the robot control unit.

Because both the control module 126 and the position of the extruder head 142 are controlled by the robot control unit 117, the control unit can vary the pressure applied to the material by the pressure control module while varying position or speed of the extruder head. For example, the command module can reduce the pressure applied to the material 111 in the extruder chamber 141, when the robotic applicator head slows down to apply a bead to a curve on the substrate, thus, the flow of material out the extrusion head is able to correspondingly slow down. Additionally, the control module can control the pressure to preferably maintain constant desired extrusion pressure while accounting for variations in the required applied pressure due to the diminishing volume of the material in the extruder chamber 141 as the material is being extruded. Typically, the force required to extrude the fluent polymeric material out a needle of 0.838 mm (0.033 in.) diameter is between 2.758 and 11.032 bar (40 and 160 psi).

When it is desired to terminate the formation of a bead the control module 126 reduces the pressure supplied to the fluent polymeric material 111 by connecting the vacuum pump 125 to the chamber. The control module can control the amount of negative gage pressure in 25 increments varying from no vacuum to the maximum vacuum available from the vacuum pump. The vacuum pump enables the bead termination to be controlled with great precision.

Having described the apparatus, a representative method of operation is now provided. The constituent components of the fluid polymeric are placed in the chambers 62, 64 and/or 66. For example, chamber 62 can contain a first pre-mixed component including a vinyl-terminated siloxane polymer, a catalyst, and electrically-conductive particles. Chamber 64 can contain a second pre-mixed component including a hydride-terminated siloxane polymer and vinyl-terminated siloxane polymer, and electrically-conductive particles. Exemplary first and second components, absent the electrically-conductive particles, are available commercially from Dow Corning as SYLGARD™ 527A and 527B. Chamber 66 can contain one or more additives as described above (microspheres, fumed silica, viscosity-adjuster, electrically-conductive particles, cure inhibitor, cure accelerator, or the like).

A proportioning pneumatic cylinder responds to a command signal supplied by the robot control unit to actuate rams 82, 83, and/or 84 to slide into the chambers 62, 64 and/or 66 so that a predetermined amount of material is fed into the mixing chamber 78 and mixed in a dynamic mixing process by a mixer 79, to form a hardenable, fluent polymeric material which can be cured, by heat according to a preferred embodiment, after extrusion.

The material then flows through conduit 165 when the valve 166 is opened by the robotic control unit. The valve 166 controls the amount of material which flows into the extruder chamber 141. When a predetermined amount of material is fed into the extruder chamber 141, the valve 166 is shut. Typically, the amount of material which is fed into the extruder chamber 141 is enough for at least several minutes of operation of the machine. Once the valve 166 is shut the pressure from the air compressor is supplied to the extrusion chamber by the operation of the control module 126. As the pressure is increased a sufficient amount so that the material is extruded out the extruder head, the extruder head simultaneously moves along the predetermined path where a continuous encircling bead is to be formed. As indicated above, the speed of the extruder head can be varied while simultaneously varying the pressure behind the pressure in the extrusion chamber by the control module 126, this provides for precise control of the bead formation process.

In a preferred embodiment of the invention, for example using the apparatus described above, the process for forming a FIP electrically conductive EMI shielding gasket forms a gasket having a cross-sectional area of preferably about $0.0013$ cm$^2$ to about $0.1008$ cm$^2$ ($0.0002$ in$^2$ to about $0.01563$ in$^2$) and which gasket is formed by extruding a fluent organic polymeric material which has electrically conductive particles disbursed therein, with the polymeric material acting as a binder. The material is extruded through an extrusion head by the force of pressurized gas. The rate of extrusion is controlled by varying the air pressure applied to the surface of the material within the extrusion head. The organic polymeric material selected to be extruded preferably has a viscosity in the range of between $10^3$ and $10^5$ g cm$^{-1}$s$^{-1}$ ($100,000$ and $10,000,000$ centipoise) measured at $25°C$ by a Brookfield Viscometer. As the material is extruded from the extrusion head, the head is moved relative to a substrate and a bead is formed on the substrate. The head can preferably move at a speed of from about $12.7$ mm/s ($0.5$ in/sec) to about $152.4$ mm/s ($6.0$ in/sec) with respect to the substrate during the formation of the bead. The bead is preferably formed with a precision of about $0.0508$ mm ($0.002$ in.) in height or width. The bead is precisely formed by varying the air pressure within a range of about $11.03$ bar ($160$ psi) of positive pressure to about $-0.912$ bar ($-0.9$ atmospheres (atm)) of negative pressure on fluent polymeric material to start and stop the bead being extruded.

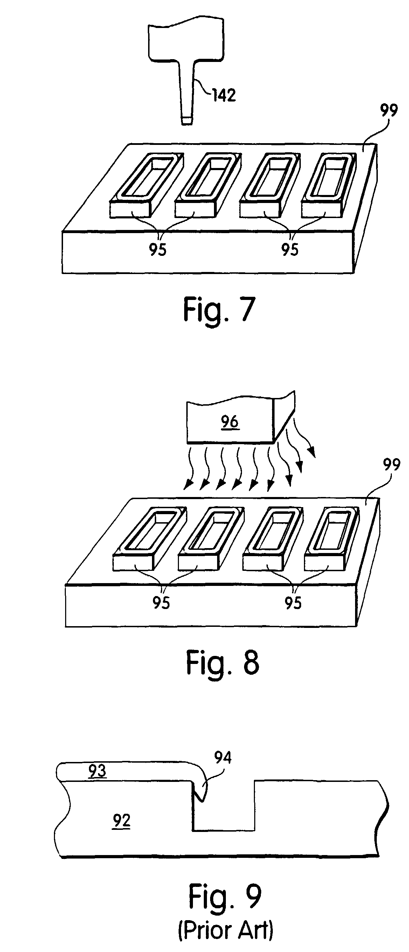

As shown in Fig. 7, several separate substrates or parts 95 can be located on a pallet 99 and the robotic extrusion head 142 can be programmed to form a bead in predetermined locations along the edge of the individual parts. Four parts 95 are shown on the pallet 99 in Fig. 7, it should be recognized that as few as one or as many as parts which can conveniently fit onto a pallet can be used. In the current design, the pallet remains stationary while the bead is being extruded by the extrusion head. It should be recognized that an alternative design could be to program the tables so that the pallet moves along a predetermined path so that a stationary head can deposit the bead on the parts 95. The parts 95 are shown in Fig. 7 as having a bead only in the X and Y direction, it should be recognized that the device can deposit a bead along the X, Y and Z axis. After each part on the pallet has been supplied with a bead, the pallet is moved to an oven 96 for heat curing, as shown in Fig. 8. Typically, the heat cure process will be of a temperature $150°C$ for about a half hour. The range of cure temperatures could be as low as $75°C$ and as high as $180°C$. After the heat curing, the parts are subsequently cooled.

Fig. 9 shows a non-electrically conductive bead 93 formed on a substrate 92 by a method of the prior art. The "drool" or drip 94 is formed at the termination of the bead 93 because the bead formation process lacks the control of the present invention.

Having described and illustrated this invention in detail, those skilled in the art upon reading the description that numerous modifications may be made without departing from the spirit of the invention. Therefore, it is not intended that the scope of the invention be limited to the specific embodiments described. For example, as indicated above, the extruder head can be made to stay stationary and the table can move along the predetermined path to supply the bead on the substrate. The various chambers, mixers, valves and other components can vary greatly in size, shape and structure for specific applications as will be known to those skilled in the art. While the bead formed can be heat cured when certain materials are used, in some cases the oven can be eliminated and moisture curing used with certain material. Moreover the use of positive and negative gas pressure activation and stopping of any extruded bead of gasket material can be carried out with a wide variety of materials.

The description above, and that which follows, is only meant to describe particularly advantageous embodiments of the present invention and as such is only meant to illustrate, not limit it.

Example 1

Part A contains 22.4 parts of silicone resin (Dow Coming 527 Part A), 77.6 parts of silver plated glass spheres, (avg. size 30-50 μm). Part B contains 22.3 of silicone resin (Dow Coming 527 Part B), 0.4 of hydride-terminated siloxane (Dow Coming 184 Part B), 77.3 of silver plated glass spheres (30 to 50 μm average).

Part A and Part B are mixed separately by hand until each is homogenous. Then equal parts are added and mixed by hand until homogenous.

The mixed material is added to a 10cc syringe with a needle tip of 0.832 mm (0.033 in.) diameter. The syringe is mounted onto a dispensing head of a CAM-A-LOT™ Model 1818 x-y Positioning/ Dispensing System. The material is forced put of the syringe via air pressure of about 6.206 bar (90 psi) in programmed patterns onto an aluminum flange (76.2 mm (3 inches) diameter, 6.35 mm (25 inch) thickness) which is mounted on a stationary table. The sample is cured in a hot air circulating oven for 60 minutes at 100°C.

The flange is cooled and placed in an Instron machine in a modified ASTM D-575 Compression Testing fixture. Electrodes are placed into the flange opposite facing aluminum surface and the sample is compressed at a rate of 0.127mm/min (0.005 inch/minute) to a total compression of 50% of the original gasket height. During compression, stress, strain and resistivity values are recorded.

Following the compression testing, the flange is removed and bolted to a second flange (with no gasket) until the gasket is compressed to 50% its original height. The assembly is heated in a hot air circulating oven for 22 hours at 85°C. The sample is removed, disassembled and allowed to cool and recover for 30 minutes. The gasket height is remeasured and compression set calculated as:

$$\% \text{ set} = (\text{Original height} - \text{Final height})/(\text{Original height} - \text{Deflected height})$$

The results of those tests are shown in Table 1.

Example 2

A conductive particle-filled, foamed silicone gasket is prepared and tested in the manner set forth in Example 1. The Components of Example 2 are: Part A - 21.6 Silicone RTV Foam (Dow Coming RTV silicone foam #3-6548 A/B), 75.7 Silver Powder mesh aperture size 0,044 mm (325 mesh)) 2.7 Toluene. Part B: 21.4 Silicone RTV Foam (Dow RTV #3-6548 A/B), 74.9 Silver Powder, 1.1 Hydride terminated siloxane (Dow Corning 184 Part B), 2.6 - Toluene. The results are shown in Table 1.

Example 3

A conductive coating over a nonconductive underlayer form-in-place gasket is prepared as follows. The underlayer is prepared and applied as taught in Example 1. The underlayer or core comprises: Part A - 84.2 - Silicone RTV Foam (Dow RTV #3-6548 A/B), 10.5 - Cab-o-Sil (silica), 5.3 - Toluene. Part B - 80.8 - Silicone RTV Foam (Dow RTV #3-6548 A/B), 4.0 - Hydride terminated siloxane (SYLGARD™, 184B), 10.1 - Cab-o-Sil (silica), 5.1 - Toluene.

After formation and cure, a conductive coating formed of silicone RTV, catalyst, solvent and silver coated glass conductive filler is applied by brush to the outer surfaces of the underlayer. The coating is comprised of two parts: Part A - 11.5 - RTV Silicone, 4.71 - Silver Powder, 11.8 - Silver Flake, 29.6 - Toluene. Part B - 100 RTV Silicone.

The Parts are mixed in a ratio of 100 Part A to 1.21 Part B (by weight). The results are shown in Table 1.

Example 4

A stock, linear piece of conductive gasket, known as CHO-SEAL™ 1350 gasket, available from Chomerics, Inc. and formed of a conductively filled silicone rod, 1.524mm (.060 inch) in diameter is tested for compression and resistivity values. The results are shown in Table 1.

Example 5

A conductive flocked form-in-place is formed of a urethane under layer applied and cured

TABLE 1

| EXAMPLE | FORCE/DEFLECTION (178.6 gcm(lb/inch)) | | | | Electrical Resistance (ohms) at stated Force/Deflection | | | | Compression Set (%) |
|---|---|---|---|---|---|---|---|---|---|
| | 10% | 20% | 30% | 40% | 10% | 20% | 30% | 40% | |
| 1 | .5 | 1.5 | 2.7 | 4.3 | .060 | .020 | .011 | .007 | 13 |
| 2 | .7 | 2.2 | 4.0 | 6.2 | .050 | .010 | .007 | .002 | 50 |
| 3 | .3 | 1.3 | 2.5 | 4.0 | .063 | .024 | .018 | .016 | 41 |
| 4 | 2.4 | 4.9 | 8.4 | 13.7 | .037 | .016 | .010 | .007 | 30 |

as described in Example 1. The outer layer of the urethane under layer is coated with a flocking adhesive which in turn is covered by a silver plated nylon flock as taught by U.S. Patent 5,115,104. The flocked gasket is placed in a hot air circulating oven for 10 minutes at 93.3°C (200°F) to cure the adhesive. The flocked gasket is found to provide EMI shielding over a wide range of frequencies.

Example 6

A urethane form-in-place conductive gasket is prepared, assembled and tested according to the procedures

15

of Example 1. The gasket is formed of 100 grams - urethane prepolymer, 3 grams - activator, 360 grams - silver powder, 1.5 grams - silica (as a reinforcing filler). The gasket is applied to and adhered to a substrate. The gasket is found to provide adequate EMI shielding over a wide range of frequencies.

**Claims**

1. A process for forming an EMI shielding gasket on a substrate (115) comprising the steps of:

   a) supplying a fluent electrically conductive polymeric material (111) to an extruder head (142) having an extrusion orifice (142a);

   b) causing said fluent polymeric material (111) to flow out of said extrusion orifice (142a) by increasing pressure on said fluent polymeric material;

   c.1) forming a bead (112) of said polymeric material (111) on said substrate (115) by

   c.2) varying the amount of pressure while varying the speed of relative motion between said extrusion orifice (142a) and said substrate (115) to maintain the formation of a desired cross section of said bead (112); and

   d) reducing the pressure to less than about 980 70 Pa (one atmosphere) to discontinue the bead formation.

2. The process according to claim 1 wherein said pressure is applied via a gas.

3. The process in accordance with claims 1 or 2 wherein said substrate (30) is mounted on a support (27) and said extrusion head (26) and said substrate (30) are moved with respect to each other along X and Z axes during said forming step.

4. The process according to any of claims 1 - 3 wherein the fluent polymeric material is supplied to the extrusion head (142) by the steps of:

   providing a first container (62) holding a first component (A) of the fluent polymeric material,

   providing a second container (64) holding a second component (B) of the fluent polymeric material,

   mixing (78, 79) the first and second components (A, B) prior to supplying the fluent polymeric material to the extrusion head.

5. The process according to any of claims 1 - 4, wherein the first component contains a catalyst having catalytic action that catalyzes a curing reaction of the polymeric material and the second component includes an electrically-conductive filler that inhibits the catalyst to adversely affect the catalytic activity of the catalyst.

6. The process according to any of claims 1 - 5 wherein said bead is formed on said substrate at a rate of movement of the extrusion head with respect to the substrate of between 12.7 mm/s and 152.4 mm/s (0,5 inches per second and 6 inches per second).

7. The process according to any of claims 1 - 6 wherein said fluent polymeric material used to form the bead is an elastomer having electrically conductive particle fillers.

8. The process according to any of claims 1 - 7 wherein the bead has a cross sectional area of about 0.00129 cm$^2$ (about 0.0002 in$^2$), the fluent polymeric material has a viscosity between 100 and 10,000 Pa·s (100,000 and 10,000,000 centipoise), and the forming step involves forming a bead on the substrate while moving said extrusion head with respect to said substrate at a speed of from 12.7 mm/s to 152.4 mm/s (0.5 in/sec to 6.0 in/sec) said bead being formed having an accuracy of about $\pm$ 0.0508 mm ($\pm$ 0.002 in).

9. The process according to any of claims 1 - 8, wherein the process includes varying said pressure in the range of from 1,103.2 kPa (160 psi) to 9,807 Pa (-0,9 atmospheres) on said fluent polymeric material to start and stop formation of the bead on the substrate.

**10.** The process according to any of claims 1 - 9, wherein said fluent polymeric material is compressible.

**11.** The process according to any of claims 1- 10 further including heat curing the fluent polymeric material after the bead is deposited on the substrate to form an electrically conductive EMI gasket.

**12.** The process according to claim 11, the process including applying the bead of fluent polymeric material to the substrate in the absence of any adhesion-promoting primer and heat curing the material to form an electrically conductive EMI gasket that is adhered to the substrate.

**13.** The process according to any one of claims 7 - 12 wherein said polymeric material comprises:

a polymeric thermal addition cure system; and

an electrically-conductive filler,

said material having bulk resistivity of less that about 0.050 ohm cm, and being readily extrudable and remaining so upon storage at room temperature for a period of up to at least one week, but upon exposure to a temperature of at least 85°C for a period of time of at least 30 minutes becoming essentially thermoset.

**14.** The process according to claim 13 wherein the polymeric thermal addition cure system comprises:

a first species having a first functional group;

a second species having a second functional group that is reactive with the first functional group in the presence of a catalyst and heat; and

a catalyst having catalytic action that in the presence of heat catalyzes a reaction between the first and second functional groups,

the electrically-conductive filler inhibiting the catalyst to adversely affect the catalytic activity of the catalyst, and the catalyst being present in an amount sufficient to retain desired catalytic activity.

**15.** The process according to claim 13 or 14 wherein said polymeric material comprises packaged as a kit:

a first container containing a first pre-mixed component including the first species, the electrically-conductive filler, and the catalyst;

a second container containing a second pre-mixed component including the first species, the second species, and the electrically-conductive filler; and

a third container containing the catalyst.

**16.** The process as in any of claims 13 - 15, wherein the electrically-conductive filler is a silver-based filler.

**17.** The process as in any of claims 13 - 16, wherein the first species comprises a siloxane polymer including vinyl functional groups, and the second species comprises a siloxane cross-linker including reactive hydrides.

**18.** The process as in any of claims 13 - 17, wherein the catalyst is a platinum catalyst.

**19.** The process as in any of claims 13 - 18, the material having a viscosity of from 100 to 10,000 Pa·s (100,000 to 10,000,000 centipoise) .

**20.** The process as in any of claims 13 - 19, the material being in the form and shape of a cured EMI shielding gasket having resistance at 25% deflection of less than 10 m ohms, resistance at 50% deflection of less than 5 m ohms, and shielding effectiveness of 10 - 120 dB at 10 MHZ to 12 GHz.

**21.** The process as in any of claims 13 - 20, the material being in the form and shape of a cured EMI shielding gasket having compression set of less than 50% after 30 minutes at 138°C when deflected 50% for 22 hours at 85°C, lap shear greater than 689.5 kPa (100 psi), and a shore A hardness of less than 90.

22. The process as in any of claims 13 - 21, the material further comprising a cure inhibitor.

23. The process as in any of claims 13 - 22, the material further comprising polymeric microspheres.

24. The process according to any one of claims 7 - 12 wherein said polymeric material comprises:

   a hardenable, fluent polymeric thermal addition cure system;

   an electrically-conductive filler;

   a catalyst having catalytic action that in the presence of heat catalyzes a reaction in the polymeric thermal addition cure system that causes the system to cure and harden,

   the electrically-conductive filler inhibiting the catalyst to adversely affect the catalytic activity of the catalyst, and the catalyst being present in an amount sufficient to retain desired catalytic activity.

25. An apparatus for extruding electrically conductive polymeric material (111) onto a substrate (115), said apparatus comprising:

   an extruder (140) having a chamber (141) with a first and a second end for holding electrically conductive polymeric material (111),

   an extrusion head (142) attached to said first end for extruding said polymeric material, said extrusion head (142) having an extrusion orifice (142a),

   means (117) for varying the speed of relative motion between said extrusion orifice (142a) and said substrate (115), and

   a source (121-124) of gas pressure connected to a control module (126),

   said control module (126) having an outlet end for selectively applying controlled gas pressure to said chamber (141),

   a conduit (129) fluidly connecting the outlet of the control module (126) with the second end of the extruder chamber (141), whereby the amount of polymeric material (111) extruded from the extrusion orifice (142a) varies with the amount of pressure applied to the second end of the extrusion head (142) such that a bead (112) is extruded without drool and with desired cross-sectional accuracy.

26. The apparatus as recited in claim 25, wherein said extruder head is movable at a rate of from 12.7 mm/s (0.5 inches per second) to 152.4 mm/s (6 inches per second) relative to the substrate and is adapted to form a bead having a cross-sectional area between 0.0013 cm$^2$ (0.0002 in$^2$) and 0.1008 cm$^2$ (0.01563 in$^2$).

27. The apparatus as recited in claim 25 or 26, wherein the extruder forms a bead with a cross section between 0.0013 cm$^2$ (0.0002 in$^2$) and 0.1008 cm$^2$ (0.01563 in$^2$) and has an accuracy of about $\pm$ 0.0508 mm ($\pm$ 0.002 in).

28. The apparatus as recited in any of claims 25 - 27, wherein the extruder head is mounted for movement along X and Y axes at a rate between 12.7 mm/s and 152.4 mm/s (0.5 in per second and 6 in per second) while forming a bead from 0.508 mm (0.020 in) to 3.175 mm (0.125 in) wide and from 0.254 mm (0.01 in) to 3.175 mm (0.125 in) high.

29. The apparatus as recited in any of claims 25 - 28, wherein the extrusion head has an orifice with a diameter of 0.635 mm (0.025 in) to 2.286 mm (0.090 in).

30. The apparatus as recited in any of claims 25 - 29, wherein the control module is constructed and arranged to apply gas pressure on the extruder chamber that varies from 9,807 Pa (-0.9 atmospheres) to 1,103.2 kPa (160 psi).

**31.** The apparatus as recited in any of claims 25 - 30, wherein the fluent polymeric material has a viscosity of 100 to 10,000 Pa·s (100,000 to 10,000,000 centipoise) .

**32.** The apparatus as recited in any of claims 25 - 31, further comprising a heat curing apparatus for curing the bead on the substrate.

**33.** An apparatus (96)as recited in any of claims 25 - 32, further comprising:

a first container for holding a supply of electrically conductive fluent polymeric material having a viscosity from 100 to 10,000 Pa·s (100,000 - 10,000,000 centipoise),

a conduit connecting said first container to said extruder for continuously supplying the fluent polymeric material to the extruder,

a valve disposed in the first conduit for controlling the flow of material to the extruder,

said extrusion head defining an orifice and connected with said chamber for extruding said bead of fluent polymeric material on said substrate, said head being movable with respect to said substrate,

a first source of gas pressure having a pressure greater than 98070 Pa (1 atmosphere) and a second source of gas pressure having a pressure less than 98070 Pa (1 atmosphere) and a control module connected to said first and second gas pressure sources to provide a desired pressure at an outlet thereof,

said control module being adapted to control the amount of pressure acting on said electrically conductive fluent polymeric material whereby the amount of fluent polymeric material extruded from the extrusion head is controlled by the amount of gas pressure supplied to the extruder and the flow of material can be stopped by reducing the air pressure in the extruder to less than about one atmosphere.

**34.** The apparatus as recited in any of claims 25 - 32, further comprising:

a first container (62) for holding a first component (A) of an electrically conductive fluent polymeric material,

a second container (64) for holding a second component (B) of said electrically conductive fluent polymeric material,

conduits (72, 74) connecting the first container (62) and the second container (64), respectively, to a mixing location (78) for mixing a predetermined amount of each component of said electrically conductive fluent polymeric material,

a conduit (165) connecting said mixing location (78) with said extruder (140) for supplying the extruder with said electrically conductive fluent polymeric material,

a support for carrying said substrate (115), said extrusion head (142) being movable with respect to the support.

**35.** The apparatus as recited in claim 34, wherein the first component contains a catalyst having catalytic action that catalyzes a curing reaction of the polymeric material and the second component includes an electrically-conductive filler that inhibits the catalyst to adversely affect the catalytic activity of the catalyst.

**Patentansprüche**

**1.** Prozess zum Bilden einer EMI Abschirmungsdichtung auf einem Substrat (115), umfassend die folgenden Schritte:

a) Zuführen eines <u>flüssigen</u> elektrisch leitenden polymerischen Materials (111) an einen Extruder-Kopf (142) mit einer Extrusions-Öffnung (142a);

b) Bewirken, dass das <u>flüssige</u> polymerische Material (111) von der Extrusions-Öffnung (142a) herausfließt, indem ein Druck auf das flüssige polymerische Material erhöht wird;

c.1) Bilden eines Wulsts (112) des polymerischen Materials (111) auf dem Substrat (115) durch

c.2) Verändern des Druckbetrags, während die Geschwindigkeit einer relativen Bewegung zwischen der Extrusions-Öffnung (142a) und dem Substrat (115) verändert wird, um die Bildung eines gewünschten Querschnitts des Wulstes (112) aufrecht zu erhalten; und

d) Verringern des Drucks auf weniger als ungefähr 98070 Pa (1 Atmosphäre), um die Wulstbildung zu unterbrechen.

2. Verfahren nach Anspruch 1, wobei der Druck über ein Gas angewendet wird.

3. Prozess gemäß Anspruch 1 oder 2, wobei das Substrat (30) auf einer Halterung (27) angebracht ist und der Extrusions-Kopf (26) und das Substrat (30) zueinander entlang der X und Z Achsen während des Bildungsschritts bewegt werden.

4. Prozess nach irgendeinem der Ansprüche 1 - 3, wobei das flüssige polymerische Material an den Extrusions-Kopf (142) durch die folgenden Schritte zugeführt wird:

Bereitstellen eines ersten Behälters (62), der eine erste Komponente (A) des flüssigen polyermischen Materials hält;

Bereitstellen eines zweiten Behälters (64), der eine zweite Komponente (B) des flüssigen polymerischen Materials hält,

Mischen (78, 79) der ersten und zweiten Komponenten (A, B) vor der Zuführung des flüssigen polymerischen Materials an den Extrusions-Kopf.

5. Prozess nach irgendeinem der Ansprüche 1 - 4, wobei die erste Komponente einen Katalysator mit einer katalytischen Wirkung enthält, die eine Aushärtungsreaktion des polymerischen Materials katalysiert, und die zweite Komponente einen elektrisch-leitenden Füllstoff umfasst, welcher den Katalysator davon abhält, die katalytische Aktivität des Katalysators in ungünstiger Weise zu beeinträchtigen.

6. Prozess nach einem der Ansprüche 1 - 5, wobei der Wulst auf dem Substrat bei einer Rate einer Bewegung des Extrusions-Kopfes bezüglich des Substrats von zwischen 12,7 mm/s und 152,4 mm/s (0,5 Inch pro Sekunde und 6 Inch pro Sekunde) gebildet wird.

7. Prozess nach einem der Ansprüche 1 - 6, wobei das flüssige polyermische Material, welches zum Bilden des Wulstes verwendet wird, ein Elastomer mit elektrisch leitenden Partikel-Füllstoffen ist.

8. Prozess nach irgendeinem der Ansprüche 1 - 7, wobei der Wulst eine Querschnittsfläche von ungefähr 0,00129 $cm^2$ (ungefähr 0,0002 $in^2$) aufweist, das flüssige polymerische Material eine Viskosität zwischen 100 und 10.000 Pa·s (100.000 und 10.000.000 Centipoise) aufweist, und der Bildungsschritt die Bildung eines Wulstes auf dem Substrat beinhaltet, während der Extrusions-Kopf bezüglich des Substrats bei einer Geschwindigkeit von 12,7 mm/s bis 152,4 mm/s (0,5 in/s bis 6,0 in/s) bewegt wird, wobei der Wulst mit einer Genauigkeit von ungefähr $\pm$ 0,0508 mm ($\pm$ 0,02 in) gebildet wird.

9. Prozess nach einem der Ansprüche 1 - 8, wobei der Prozess eine Veränderung des Drucks in dem Bereich von 1103,2 kPa (160 psi) bis 9807 Pa (-0,9 Atmosphären) auf dem flüssigen polymerischen Material umfasst, um eine Bildung des Wulstes auf dem Substrat zu starten und zu stoppen.

10. Prozess nach einem der Ansprüche 1 - 9, wobei das flüssige polyermische Material kompressibel ist.

11. Prozess nach einem der Ansprüche 1 - 10, ferner umfassend eine Wärmeaushärtung des flüssigen polymerischen Materials, nachdem die Wulst auf das Substrat abgelagert ist, um eine elektrisch leitende EMI Dichtung zu bilden.

12. Prozess nach Anspruch 11, wobei der Prozess eine Anwendung des Wulstes aus dem flüssigen polymerischen Material auf das Substrat bei Abwesenheit irgendeines Adhäsions-fördernden Primers und eine Wärmeaushärtung des Materials umfasst, um eine elektrisch leitende EMI Dichtung zu bilden, die an dem Substrat anhaftet.

**13.** Prozess nach irgendeinem der Ansprüche 7 - 12, wobei das polymerische Material umfasst:

ein polymerisches thermisches Additions-Aushärtungssystem; und

einen elektrisch-leitenden Füllstoff,

wobei das Material eine spezifische Massen-Leitfähigkeit von weniger von ungefähr 0,050 Ohm cm aufweist und leicht extrudierbar ist und auf eine Speicherung bei Raumtemperatur in für eine Periode von bis zu wenigstens einer Woche so verbleibt, aber auf eine Aussetzung einer Temperatur von wenigstens 85°C für eine Zeitperiode von wenigstens 30 Minuten hin im wesentlichen thermisch ausgehärtet wird.

**14.** Prozess nach Anspruch 13, wobei das polymerische thermische Additions-Aushärtungssystem umfasst:

einen ersten Stoff mit einer ersten funktionalen Gruppe;

einen zweiten Stoff mit einer zweiten funktionalen Gruppe, der mit der ersten funktionalen Gruppe bei Anwesenheit eines Katalysators und Wärme reaktiv ist; und

einen Katalysator mit einer katalytischen Wirkung, die bei Anwesenheit von Wärme eine Reaktion zwischen den ersten und zweiten funktionalen Gruppen katalysiert,

wobei der elektrisch-leitende Füllstoff den Katalysator davon abhält, die katalytische Aktivität des Katalysators ungünstig zu beeinträchtigen, und wobei der Katalysator in einer ausreichenden Menge zum Aufrechterhalten einer gewünschten katalytischen Aktivität vorhanden ist.

**15.** Prozess nach Anspruch 13 oder 14, wobei das polymerische Material als ein Bausatz verpackt umfasst:

einen ersten Behälter, der eine erste vor-gemischte Komponente, die den ersten Stoff umfasst, den elektrisch-leitenden Füllstoff und den Katalysator enthält;

einen zweiten Behälter, der eine zweite vor-gemischte Komponente, die den ersten Stoff umfasst, den zweiten Stoff und den elektrisch-leitenden Füllstoff enthält; und

einen dritten Behälter, der den Katalysator enthält.

**16.** Prozess nach irgendeinem der Ansprüche 13 - 15, wobei der elektrisch-leitende Füllstoff ein auf Silber basierenden Füllstoff ist.

**17.** Prozess nach irgendeinem der Ansprüche 13 - 16, wobei der erste Stoff einen Siloxan-Polymer mit Vinyl-Funktionalgruppen umfasst und der zweite Stoff einen Siloxan-Kreuzbinder mit reaktiven Hydriden umfasst.

**18.** Prozess nach einem der Ansprüche 13 - 17, wobei der Katalysator ein Platin-Katalysator ist.

**19.** Prozess nach einem der Ansprüche 13 - 18, wobei das Material eine Viskosität von 100 bis 10.000 Pa·s (100.000 bis 10.000.000 Centipoise) aufweist.

**20.** Prozess nach einem der Ansprüche 13 - 19, wobei das Material in der Form und der Gestalt einer ausgehärteten EMI Abschirmungsdichtung mit einem Widerstand von 25% Abbiegung von weniger als 10 m Ohm, einen Widerstand von 50% Abbiegung von weniger als 5 m Ohm und einen Abschirmungswirkungsgrad von 10 - 120 dB bei 10 MHZ bis 12 GHz ist.

**21.** Prozess nach einem der Ansprüche 13 - 20, wobei das Material in der Form und Gestalt einer ausgehärteten EMI Abschirmungsdichtung mit einer Kompression, die auf weniger als 50% nach 30 Minuten bei 130°C eingestellt ist, wenn 50% für 22 Stunden bei 85°C abgebogen, eine Läppungsscherung größer als 689,5 kPa (100 psi) und eine Shore A Härte von weniger als 90 ist.

**22.** Prozess nach einem der Ansprüche 13 - 21, wobei das Material einen Aushärtungs-Verhinderer umfasst.

**23.** Prozess nach einem der Ansprüche 13 - 22, wobei das Material ferner polymerische Mikrokügelchen umfasst.

**24.** Prozess nach einem der Ansprüche 7 - 12, wobei das polymerische Material umfasst:

ein härtbares, flüssiges polymerisches thermisches Adhäsions-Härtungssystem;

einen elektrisch-leitenden Füllstoff;

einen Katalysator mit einer katalytischen Wirkung, die bei Anwesenheit von Wärme eine Reaktion in dem polymerischen thermischen Additions-Härtungssystem katalysiert, was das System veranlasst, auszuhärten und hart zu werden,

wobei der elektrisch-leitende Füllstoff den Katalysator davon abhält, die katalytische Aktivität des Katalysators ungünstig zu beeinträchtigen, und wobei der Katalysator in einer ausreichenden Menge zum Aufrechterhalten einer gewünschten katalytischen Aktivität vorhanden ist.

**25.** Vorrichtung zum Extrudieren eines elektrisch-leitenden polymerischen Materials (111) auf ein Substrat (115), wobei die Vorrichtung umfasst:

einen Extruder (140) mit einer Kammer (141) mit einem ersten und einem zweiten Ende zum Halten von elektrisch leitendem polymerischen Material (111),

einen Extrusions-Kopf (142), der an dem ersten Ende angebracht ist, zum Extrudieren des polymerischen Materials, wobei der Extrusions-Kopf (142) eine Extrusions-Öffnung (142a) aufweist,

eine Einrichtung (117) zum Verändern der Geschwindigkeit einer relativen Bewegung zwischen der Extrusions-Öffnung (142a) und dem Substrat (115), und

eine Quelle (121-124) eines Gasdrucks, die mit einem Steuermodul (126) verbunden ist,

wobei das Steuermodul (126) ein Auslassende zum selektiven Anwenden eines gesteuerten Gasdruckes auf die Kammer (141) aufweist,

einen Kanal (129), der in einem flüssigen Sinne den Auslaß des Steuermoduls (126) mit dem zweiten Ende der Extruder-Kammer (141) verbindet, wobei die Menge des polymerischen Materials (111), welches von der Extrusions-Öffnung (142a) extrudiert wird, sich mit dem Druckbetrag ändert, der an das zweite Ende des Extrusions-Kopfes (142) angelegt wird, so dass eine Wulst (112) ohne Aushöhlungen und mit einer gewünschten querschnittsmäßigen Genauigkeit extrudiert wird.

**26.** Vorrichtung nach Anspruch 25, wobei der Extruder-Kopf bei einer Rate von 12,7 mm/s (0,5 Inch pro Sekunde) bis 152,4 mm/s (6 Inch pro Sekunde) relativ zu dem Substrat bewegbar ist und dafür ausgebildet ist, um einen Wulst mit einer Querschnittsfläche zwischen 0,0013 cm$^2$ (0,0002 in$^2$) und ungefähr 0,10008 cm$^2$ (0,01563 in$^2$) zu bilden.

**27.** Vorrichtung nach Anspruch 25 oder 26, wobei der Extruder eine Wulst mit einem Querschnitt zwischen 0,0013 cm$^2$ (0,0002 in$^2$) und 0,1008 cm$^2$ (0,01563 in$^2$) bildet und eine Genauigkeit von ungefähr ± 0,0508 mm (± 0,002 in) aufweist.

**28.** Vorrichtung nach einem der Ansprüche 25 - 27, wobei der Extruder-Kopf für eine Bewegung entlang der X und Y Achsen bei einer Rate zwischen 12,7 mm/s und 152,4 mm/s (0,5 in pro Sekunde und 6 in pro Sekunde) angebracht ist, während eine Wulst von 0,508 mm (0,020 in) bis 3,175 mm (0,125 in) Breite und von 0,254 mm (0,01 in) bis 3,175 mm (0,125 in) Höhe gebildet wird.

**29.** Vorrichtung nach einem der Ansprüche 25 - 28, wobei der Extrusions-Kopf eine Öffnung mit einem Durchmesser von 0,635 mm (0,025 in) bis 2,286 mm (0,090 in) aufweist.

**30.** Vorrichtung nach einem der Ansprüche 25 - 29, wobei das Steuermodul konstruiert und angeordnet ist, um einen Gasdruck auf die Extruder-Kammer anzuwenden, der sich von 9,807 Pa (-0,9 Atmosphären) bis 1,103.2 kPa (160 psi) ändert.

**31.** Vorrichtung nach einem der Ansprüche 25 - 30, wobei das flüssige polymerische Material eine Viskosität von 100 bis 10.000 Pa·s (100.000 bis 10.000.000 Centipoise) aufweist.

**32.** Vorrichtung nach einem der Ansprüche 25 - 31, ferner umfassend eine Wärmeaushärtungsvorrichtung zum Aushärten der Wulst auf dem Substrat.

**33.** Vorrichtung (96) nach einem der Ansprüche 25 - 32, ferner umfassend:

einen ersten Behälter zum Halten einer Zuführung eines elektrisch leitenden flüssigen polymerischen Materials mit einer Viskosität von 100 bis 10.000 Pa·s (100.000 - 10.000.000 Centipoise),

einen Kanal, der den ersten Behälter mit dem Extruder verbindet, zum kontinuierlichen Zuführen des flüssigen polymerischen Materials an den Extruder,

ein Ventil, welches in dem ersten Kanal zum Steuern des Flusses des Materials an den Extruder angeordnet ist,

wobei der Extrusionskopf eine Öffnung definiert und mit der Kammer verbunden ist, zum Extrudieren des Wulstes aus dem flüssigen polymerischen Material auf das Substrat, wobei der Kopf bezüglich des Substrats bewegbar ist,

eine erste Quelle mit einem Gasdruck, die einen Druck aufweist, der größer als 98070 Pa (1 Atmosphäre) ist, und eine zweite Quelle mit einem Gasdruck, die einen Druck aufweist, der geringer als 98070 Pa (1 Atmosphäre) ist, und ein Steuermodul, welches mit den ersten und zweiten Gasdruckquellen verbunden ist, um einen gewünschten Druck an einem Auslaß davon bereitzustellen, wobei das Steuermodul dafür ausgelegt ist, den Druckbetrag, der auf das elektrisch-leitende flüssige polymerische Material wirkt, zu steuern, wodurch die Menge des flüssigen polymerischen Materials, welches aus dem Extrusionskopf extrudiert wird, durch den Gasdruckbetrag gesteuert wird, der an den Extruder angelegt wird, und der Materialfluss durch Verringern des Luftdrucks in dem Extruder auf weniger als ungefähr 1 Atmosphäre gestoppt werden kann.

**34.** Vorrichtung nach einem der Ansprüche 25 - 32, ferner umfassend:

einen ersten Behälter (62) zum Halten einer ersten Komponente (A) aus einem elektrisch-leitenden flüssigen polymerischen Material,

einen zweiten Behälter (64) zum Halten einer zweiten Komponente (B) des elektrisch leitenden flüssigen polymerischen Materials,

Kanäle (72, 74), die den ersten Behälter (62) und den zweiten Behälter (64) jeweils mit einer Mischstelle (78) zum Mischen einer vorgegebenen Menge jeder Komponente des elektrisch-leitenden flüssigen polymerischen Materials verbindet,

einen Kanal (165), der die Mischstelle (78) mit dem Extruder (140) verbindet, um an den Extruder das elektrisch-leitende flüssige polymerische Material zuzuführen, und

eine Halterung zum Tragen des Substrats (115), wobei der Extrusions-Kopf (142) bezüglich der Halterung bewegbar ist.

**35.** Vorrichtung nach Anspruch 34, wobei die erste Komponente einen Katalysator mit einer katalytischen Wirkung enthält, die eine Aushärtungsreaktion des polymerischen Materials katalysiert, und die zweite Komponente einen elektrisch-leitenden Füllstoff umfasst, der den Katalysator davon abhält, die katalytische Aktivität des Katalysators ungünstig zu beeinträchtigen.

**Revendications**

**1.** Procédé de formation d'un joint de protection EMI sur un substrat (115), comprenant les étapes consistant à :

a) fournir un matériau polymérique fluide conducteur de l'électricité (111) à une tête d'extrusion (142) présentant un orifice d'extrusion (142a);

b) amener ledit matériau polymérique fluide (111) à s'écouler hors dudit orifice d'extrusion (142a) en augmentant la pression sur ledit matériau polymérique fluide;

c.1) former un cordon (112) dudit matériau polymérique (111) sur ledit substrat (115) en

c.2) faire varier la valeur de la pression tout en faisant varier la vitesse de déplacement relatif entre ledit orifice d'extrusion (142a) et ledit substrat (115) pour conserver la formation d'une section transversale souhaitée dudit cordon (112), et

d) réduire la pression à moins d'environ 98 070 Pa (une atmosphère) pour interrompre la formation du cordon.

**2.** Procédé suivant la revendication 1, dans lequel ladite pression est appliquée par l'intermédiaire d'un gaz.

**3.** Procédé suivant la revendication 1 ou 2, dans lequel ledit substrat (30) est monté sur un support (27) et ladite tête d'extrusion (26) et ledit substrat (30) sont déplacés l'un par rapport à l'autre suivant les axes X et Z pendant ladite étape de formation.

**4.** Procédé suivant l'une quelconque des revendications 1 à 3, dans lequel le matériau polymérique fluide est amené à la tête d'extrusion (142) par les étapes consistant à:

procurer un premier récipient (62) contenant un premier composant (A) du matériau polymérique fluide,

procurer un deuxième récipient (64) contenant un deuxième composant (B) du matériau polymérique fluide,

mélanger (78, 79) les premier et deuxième composants (A, B) avant de fournir le matériau polymérique fluide à la tête d'extrusion.

**5.** Procédé suivant l'une quelconque des revendications 1 à 4, dans lequel le premier composant contient un catalyseur présentant une action catalytique qui catalyse une réaction de durcissement du matériau polymérique, et le deuxième composant comprend une charge conductrice de l'électricité qui inhibe le catalyseur pour affecter l'activité catalytique du catalyseur.

**6.** Procédé suivant l'une quelconque des revendications 1 à 5, dans lequel ledit cordon est formée sur ledit substrat à une vitesse de déplacement de la tête d'extrusion par rapport au substrat entre 12,7 mm/s et 152,4 mm/s (0,5 pouce par seconde et 6 pouces par seconde).

**7.** Procédé suivant l'une quelconque des revendications 1 à 6, dans lequel ledit matériau polymérique fluide utilisé pour former le cordon est un élastomère avec des charges particulaires conductrices de l'électricité.

**8.** Procédé suivant l'une quelconque des revendications 1 à 7, dans lequel le cordon a une section transversale d'une surface d'environ 0,00129 cm$^2$ (environ 0,0002 pouce$^2$), le matériau polymérique fluide a une viscosité entre 100 et 10 000 Pa•s (100 000 et 10 000 000 centipoises), et l'étape de formation comprend la formation d'un cordon sur le substrat pendant le déplacement de ladite tête d'extrusion par rapport audit substrat à une vitesse d'environ 12,7 mm/s à 152,4 mm/s (0,5 pouce/s à 6,0 pouces/s) ledit cordon en formation ayant une précision d'environ $\pm$ 0,0508 mm ($\pm$ 0,002 pouce).

**9.** Procédé suivant l'une quelconque des revendications 1 à 8, dans lequel le procédé comprend l'étape consistant à faire varier ladite pression dans l'intervalle de 1 103,2 kPa (160 psi) à 9 807 Pa (-0,9 atmosphère) sur ledit matériau polymérique fluide pour commencer et arrêter la formation du cordon sur le substrat.

**10.** Procédé suivant l'une quelconque des revendications 1 à 9, dans lequel ledit matériau polymérique fluide est compressible.

**11.** Procédé suivant l'une quelconque des revendications 1 à 10, comprenant en outre un durcissement thermique du matériau polymérique fluide après que le cordon soit déposé sur le substrat, pour former un joint EMI conducteur de l'électricité.

**12.** Procédé suivant la revendication 11, le procédé comprenant l'application du cordon de matériau polymérique fluide sur le substrat en l'absence d'un quelconque apprêt promoteur d'adhérence, et le durcissement thermique du matériau pour former un joint EMI conducteur de l'électricité qui adhère au substrat.

**13.** Procédé suivant l'une quelconque des revendications 7 à 12, dans lequel ledit matériau polymérique comprend :

un système de durcissement thermique par addition polymérique, et

une charge conductrice de l'électricité,

ledit matériau présentant une résistivité en vrac de moins d'environ 0,050 ohm cm, et pouvant facilement être extrudé et restant dans cet état lors d'un stockage à température ambiante pendant une période allant jusqu'à au moins une semaine, mais devenant

essentiellement thermodurci lors d'une exposition à une température d'au moins 85°C pendant un laps de temps d'au moins 30 minutes.

**14.** Procédé suivant la revendication 13, dans lequel le système de durcissement par addition thermique polymérique comprend :

une première substance présentant un premier groupement fonctionnel;

une deuxième substance présentant un deuxième groupement fonctionnel qui est réactif avec le premier groupement fonctionnel en présence d'un catalyseur et de chaleur ; et

un catalyseur présentant une action catalytique qui, en présence de chaleur, catalyse une réaction entre les premier et deuxième groupements fonctionnels,

la charge conductrice de l'électricité inhibant le catalyseur pour affecter l'activité catalytique du catalyseur, et le catalyseur étant présent en une quantité suffisante pour maintenir l'activité catalytique souhaitée.

**15.** Procédé suivant la revendication 13 ou 14, dans lequel ledit matériau polymérique comprend, emballé sous forme de kit :

un premier récipient contenant un premier composant pré-mélangé comprenant la première substance, la charge conductrice de l'électricité, et le catalyseur;

un deuxième récipient contenant un deuxième composant pré-mélangé comprenant la première substance, la deuxième substance, et la charge conductrice de l'électricité, et

un troisième récipient contenant le catalyseur.

**16.** Procédé suivant l'une quelconque des revendications 13 à 15, dans lequel la charge conductrice de l'électricité est une charge à base d'argent.

**17.** Procédé suivant l'une quelconque des revendications 13 à 16, dans lequel la première substance comprend un polymère siloxane comprenant des groupements fonctionnels vinyle, et la deuxième substance comprend un réticulant siloxane comprenant des hydrures réactifs.

**18.** Procédé suivant l'une quelconque des revendications 13 à 17, dans lequel le catalyseur est un catalyseur au platine.

**19.** Procédé suivant l'une quelconque des revendications 13 à 18, le matériau présentant une viscosité de 100 à 10 000 Pa•s (100 000 à 10 000 000 centipoises).

**20.** Procédé suivant l'une quelconque des revendications 13 à 19, le matériau étant sous forme et en forme d'un joint de protection EMI présentant une résistance de moins de 10 m ohms à 25% de déflexion, une résistance de moins de 5 m ohms à 50% de déflexion, et une efficacité de protection de 10 - 120 dB dans l'intervalle de 10 MHz à 12 GHz.

**21.** Procédé suivant l'une quelconque des revendications 13 à 20, le matériau étant sous forme et en forme d'un joint de protection EMI présentant une déformation rémanente à la compression inférieure à 50% après 30 minutes à 138°C lorsqu'il est fléchi à 50% pendant 22 heures à 85°, une contrainte de cisaillement à recouvrement supérieure à 689,5 kPa (100 psi), et une dureté shore A de moins de 90.

**22.** Procédé suivant l'une quelconque des revendications 13 à 21, le matériau comprenant en outre un inhibiteur de durcissement.

**23.** Procédé suivant l'une quelconque des revendications 13 à 22, le matériau comprenant en outre des microsphères polymériques.

**24.** Procédé suivant l'une quelconque des revendications 7 à 12, dans lequel ledit matériau polymérique comprend :

un système fluide, pouvant se solidifier, à durcissement thermique par addition polymérique;
une charge conductrice de l'électricité;
un catalyseur présentant une action catalytique qui, en présence de chaleur, catalyse une réaction dans le système de durcissement thermique par addition polymérique, qui amène le système à durcir et à se solidifier, la charge conductrice de l'électricité inhibant le catalyseur pour affecter l'activité catalytique du catalyseur, et le catalyseur étant présent en une quantité suffisante pour maintenir l'activité catalytique souhaitée.

25. Appareil pour extruder un matériau polymérique conducteur de l'électricité (111) sur un substrat (115), ledit appareil comprenant :

une extrudeuse (140) présentant une chambre (141) avec une première et une deuxième extrémités, destinée à contenir le matériau polymérique conducteur de l'électricité (111),
une tête d'extrusion (142) fixée à ladite première extrémité pour extruder ledit matériau polymérique, ladite tête d'extrusion (142) présentant un orifice d'extrusion (142a),
un moyen (117) pour faire varier la vitesse de déplacement relatif entre ledit orifice d'extrusion (142a) et ledit substrat (115), et
une source (121-124) de gaz sous pression reliée à un module de commande (126),
ledit module de commande (126) présentant une extrémité de sortie pour appliquer sélectivement une pression contrôlée de gaz à ladite chambre (141),
un conduit (129) reliant pour un fluide la sortie du module de commande (126) à la deuxième extrémité de la chambre d'extrudeuse (141), par lequel la quantité de matériau polymérique (111) extrudée de l'orifice d'extrusion (142a) varie avec la valeur de la pression appliquée à la deuxième extrémité de la tête d'extrusion (142) de sorte qu'un cordon (112) est extrudée sans baver et avec la précision souhaitée de section transversale.

26. Appareil selon la revendication 25, dans lequel ladite tête d'extrusion peut être déplacée à une vitesse de 12,7 mm/s (0,5 pouce par seconde) à 152,4 mm/s (6 pouces par seconde) par rapport au substrat et est adaptée pour former un cordon présentant une superficie de section transversale entre 0,0013 cm$^2$ (0,0002 pouce$^2$) et 0,1008 cm$^2$ (0,01563 pouce$^2$).

27. Appareil selon la revendication 25 ou 26, dans lequel l'extrudeuse forme un cordon avec une section transversale entre 0,0013 cm$^2$ (0,0002 pouce$^2$) et 0,1008 cm$^2$ (0,01563 pouce$^2$) et a une précision d'environ ± 0,0508 mm (± 0,002 pouce).

28. Appareil tel que décrit dans l'une quelconque des revendications 25 à 27, dans lequel la tête d'extrusion est montée pour un déplacement le long des axes X et Y à une vitesse entre 12,7 mm/s et 152,4 mm/s (0,5 pouce par seconde et 6 pouces par seconde) pendant qu'elle forme un cordon de 0,508 mm (0,020 pouce) à 3,175 mm (0,125 pouce) de large et de 0,254 mm (0,01 pouce) à 3,175 mm (0,125 pouce) de haut.

29. Appareil tel que décrit dans l'une quelconque des revendications 25 à 28, dans lequel la tête d'extrusion a un orifice présentant un diamètre de 0,635 mm (0,025 pouce) à 2,286 mm (0,090 pouce).

30. Appareil tel que décrit dans l'une quelconque des revendications 25 à 29, dans lequel le module de commande est construit et agencé pour appliquer sur la chambre d'extrudeuse une pression de gaz qui varie de 9 807 Pa (-0,9 atmosphère) à 1 103,2 kPa (160 psi).

31. Appareil tel que décrit dans l'une quelconque des revendications 25 à 30, dans lequel le matériau polymérique fluide a une viscosité de 100 à 10 000 Pa·s (100 000 à 10 000 000 centipoises).

32. Appareil tel que décrit dans l'une quelconque des revendications 25 à 31, comprenant en outre un appareil de durcissement thermique pour durcir le cordon sur le substrat.

33. Appareil (96) tel que décrit dans l'une quelconque des revendications 25 à 32, comprenant en outre :

un premier récipient pour contenir une source de matériau polymérique fluide, conducteur de l'électricité, présentant une viscosité de 100 à 10 000 Pa•s (100 000 - 10 000 000 centipoises),
un conduit reliant ledit premier récipient à ladite extrudeuse pour fournir de manière continue le matériau polymérique fluide à l'extrudeuse,

une vanne placée dans le premier conduit pour commander le flux de matériau vers l'extrudeuse,

ladite tête d'extrusion définissant un orifice, et reliée à ladite chambre pour extruder ledit cordon de matériau polymérique fluide sur ledit substrat, ladite tête pouvant être déplacée par rapport audit substrat,

une première source de pression de gaz présentant une pression supérieure à 98 070 Pa (1 atmosphère) et une deuxième source de pression de gaz présentant une pression inférieure à 98 070 Pa (1 atmosphère) et un module de commande relié auxdites première et deuxième sources de pression de gaz pour procurer une pression souhaitée à une sortie de celles-ci,

ledit module de commande étant adapté pour commander la valeur de la pression agissant sur ledit matériau polymérique fluide conducteur de l'électricité, ce par quoi la quantité de matériau polymérique fluide extrudée de la tête d'extrusion est contrôlée par la valeur de la pression de gaz fournie à l'extrudeuse, et le flux de matériau peut être arrêté en réduisant la pression d'air dans l'extrudeuse jusqu'à moins d'environ une atmosphère.

**34.** Appareil tel que décrit dans l'une quelconque des revendications 25 à 32, comprenant en outre :

un premier récipient (62) pour contenir un premier composant (A) d'un matériau polymérique fluide conducteur de l'électricité,

un deuxième récipient (64) pour contenir un deuxième composant (B) dudit matériau polymérique fluide conducteur de l'électricité,

des conduits (72, 74) reliant le premier récipient (62) et le deuxième récipient (64) respectivement à un emplacement de mélange (78), pour mélanger une quantité prédéterminée de chaque composant dudit matériau polymérique fluide conducteur de l'électricité,

un conduit (165) reliant ledit emplacement de mélange (78) à ladite extrudeuse (140) pour fournir à l'extrudeuse ledit matériau polymérique fluide conducteur de l'électricité,

un support pour supporter ledit substrat (115), ladite tête d'extrusion (142) pouvant être déplacée par rapport au support.

**35.** Appareil selon la revendication 34, dans lequel le premier composant contient un catalyseur présentant une action catalytique qui catalyse une réaction de durcissement du matériau polymérique et le second composant comprend une charge conductrice de l'électricité qui inhibe le catalyseur pour affecter l'activité catalytique du catalyseur.

Fig. 1

Fig. 2

EP 0 804 868 B1

Fig. 3

Fig. 4

Fig. 5

Fig. 6

EP 0 804 868 B1

Fig. 7

Fig. 8

Fig. 9
(Prior Art)